# EUROPEAN PATENT APPLICATION

(11) **EP 4 766 062 A1**
(43) Date of publication of application: **24.06.2026**
(21) Application number: 25806714.9
(22) Date of filing: 15.04.2025
(51) Int. Cl.: H05K 7/20, H05K 5/02, H05K 5/06, H04M 1/02

(54) **MOBILE TERMINAL**

(30) Priority: 24.05.2024 CN 202410666444
(71) Applicant: HUAWEI TECHNOLOGIES CO., LTD., Shenzhen 518129 (CN)
(72) Inventor: JIN, Linfang, Shenzhen, Guangdong 518129 (CN); LUO, Yang, Shenzhen, Guangdong 518129 (CN); WANG, Yingxian, Shenzhen, Guangdong 518129 (CN); CHEN, Qiu, Shenzhen, Guangdong 518129 (CN)
(74) Representative: Grünecker Patent- und Rechtsanwälte PartG mbB
(86) International application number: PCT/CN2025/089052
(87) International publication number: WO 2025/241775

(57) **Abstract**

Embodiments of this application relate to the field of electronic product technologies, and provide a mobile terminal. The mobile terminal includes a housing assembly, a fan module, and a first mechanical part. The first mechanical part is disposed on an inner wall of the housing assembly, and the first mechanical part and the housing assembly enclose a fan installation cavity. The housing assembly is provided with a fan socket communicating the fan installation cavity with an outer side of the housing assembly, and the fan module is inserted into the fan installation cavity through the fan socket. When the mobile terminal is in a fan locked state, the fan module is locked and fastened to the first mechanical part. When the mobile terminal is in a fan unlocked state, the fan module is unfastened from the first mechanical part, and the fan module is movable between an insertion position and a protruding position in a plugging direction of the fan module. In this way, routine maintenance and repair can be performed on the fan module of the mobile terminal conveniently. This is applicable to mobile terminals such as a bar-type mobile phone, a foldable mobile phone, a tablet, and a wearable device, and use of the entire mobile terminal with high performance and high system reliability can be supported.

## Description

This application claims priority to Chinese Patent Application No. 202410666444.2, filed with the China National Intellectual Property Administration on May 24, 2024 and entitled "MOBILE TERMINAL", which is incorporated herein by reference in its entirety.

### TECHNICAL FIELD

Embodiments of this application relate to the field of electronic product technologies, and in particular, to a mobile terminal.

### BACKGROUND

As performance of mobile terminals such as a mobile phone, a tablet computer, and a smartwatch is continuously improved, thermal design has become a bottleneck of the performance of the mobile terminal. A current mobile terminal, for example, a mobile phone, usually performs natural heat dissipation through internal heat equalizing by using a heat pipe, a vapor chamber (VC), a graphite sheet, a graphene film, a thermal interface material (thermal interface material, TIM), and the like. Because a volume and a thickness of the mobile terminal are strictly limited, natural heat dissipation hardly meets a power consumption requirement of applications such as AI, a game, a video call, and satellite communication. An equivalent heat exchange coefficient of active air-cooling heat dissipation performed by using a fan module may reach 2 to 10 times that of natural heat dissipation. In comparison with natural heat dissipation, active air-cooling heat dissipation can improve a heat dissipation capability by more than 50%, and is an important way to improve the performance of the mobile terminal.

In a related technology, the fan module is usually disposed in a housing assembly of the mobile terminal. A problem like falling, squeezing, or collision easily occurs in a process of using or carrying the mobile terminal. When falling, squeezing, or collision occurs, the fan module is vulnerable to a large local impact force, and a risk is far higher than that of a fan module in a static application scenario. The fan module is relatively more likely to partially deform. In this case, performance of the fan module is easily affected. In addition, when the fan module is used for a long time, dust, fiber dirt, and the like in an environment accumulate on a blade surface and an air duct of the fan module. This causes continuous attenuation of an air volume and a heat dissipation capability of the fan module, and causes problems such as noise and abnormal sound. Currently, it is difficult for a user to maintain the fan module. Reliability of the fan module used as a moving part restricts the performance of the mobile terminal. If performance such as heat dissipation, noise, or vibration of the fan module significantly deteriorates, the fan module needs to be repaired after the mobile terminal is disassembled (for example, a rear cover or a display is removed). Some mobile terminals have high requirements on a waterproof and dustproof level. Disassembling of the mobile terminals may damage waterproof and dustproof and sealing requirements of the mobile terminals. This may easily cause scrapping of the entire mobile terminals. Therefore, operability of disassembling the mobile terminal to repair the fan module is poor. In addition, in a process of disassembling the mobile terminal to repair the fan module, other components or devices such as the housing assembly, a side button, the display, and a battery may be scratched. This may easily cause scrapping of the other components or devices.

Therefore, in the mobile terminal in the related technology, it is difficult to perform routine maintenance and repair on the fan module. Consequently, reliability of the fan module and the mobile terminal that uses the fan module is low, and the fan module and the mobile terminal cannot be widely used in the future. This restricts full play of the performance of the mobile terminal like the mobile phone.

### SUMMARY

Embodiments of this application provide a mobile terminal, so that routine maintenance and repair can be performed on a fan module of the mobile terminal conveniently.

Embodiments of this application provide a mobile terminal. The mobile terminal includes a housing assembly, a fan module, and a first mechanical part. The first mechanical part is securely disposed on an inner wall of the housing assembly, and the first mechanical part and the housing assembly enclose a fan installation cavity. The housing assembly is provided with a fan socket communicating the fan installation cavity with an outer side of the housing assembly, and the fan module is inserted into the fan installation cavity through the fan socket. The mobile terminal has a fan locked state and a fan unlocked state. When the mobile terminal is in a fan locked state, the fan module is locked and fastened to the first mechanical part. When the mobile terminal is in the fan unlocked state, the fan module is unfastened from the first mechanical part, and the fan module is movable between an insertion position and a protruding position in a first direction, to enable at least a part of the fan module to protrude to the outer side of the housing assembly through the fan socket, or at least a part of the fan module to be inserted back into the fan installation cavity through the fan socket. The first direction is a plugging direction of the fan module.

According to the mobile terminal provided in embodiments of this application, when routine maintenance or repair needs to be performed on the fan module, at least a part of the fan module can protrude to the outer side of the housing assembly through the fan socket, to facilitate maintenance such as daily dust removal and cleaning or repair work such as replacement of the fan module. After the fan module is maintained or repaired, the fan module may be inserted back into the fan installation cavity through the fan socket. When maintaining or repairing the fan module, a display, a side edge, and a rear cover do not need to be removed, or sealing between the display, the side edge, and the rear cover is not damaged. After the fan module is repaired, the display, the side edge, and the rear cover do not need to be sealed again. In conclusion, maintenance and repair costs of the fan module are low, operation difficulty is low, and the entire mobile terminal is not easily scrapped. In addition, when the fan module protruding to the outer side of the housing assembly is repaired, a repair tool does not need to protrude into the housing assembly. In this case, it is not easy to damage another component or device of the mobile terminal and cause scrapping of the another component or device, and the repair costs are low. According to the mobile terminal provided in embodiments of this application, it is convenient to maintain or repair the fan module. In addition, the first mechanical part is disposed to form the fan installation cavity for the fan module to be inserted, so that the fan module is securely fastened and securely connected to the housing assembly. When the mobile terminal is in the fan locked state, the fan module may be securely locked and fastened to the housing assembly. This helps maintain performance of the fan module. When the mobile terminal is in the fan unlocked state, the fan module may move in the first direction. This is easy to operate. Protruding and inserting processes of the fan module are not easy to cause damage to the entire mobile terminal.

In some possible implementations, the mobile terminal further includes a power supply device and an electrical connection device. The housing assembly is further provided with a device installation cavity located outside the fan installation cavity, the power supply device is disposed in the device installation cavity, a part of the electrical connection device is located in the device installation cavity, and a part of the electrical connection device is located in the fan installation cavity. When the fan module is at the insertion position, the fan module is electrically connected to the power supply device through the electrical connection device. In this way, the power supply device disposed in the device installation cavity may supply power to the fan module at the insertion position, to drive the fan module when the fan module is at the insertion position. When the fan module runs at the insertion position, overall anti-falling performance of the mobile terminal is good, and an appearance of the mobile terminal does not change.

In some possible implementations, the mobile terminal further includes a power supply device and an electrical connection device. The housing assembly is further provided with a device installation cavity located outside the fan installation cavity, the power supply device is disposed in the device installation cavity, a part of the electrical connection device is located in the device installation cavity, and a part of the electrical connection device is located in the fan installation cavity. When the fan module is at the protruding position, the fan module is electrically connected to the power supply device through the electrical connection device. In this way, the power supply device disposed in the device installation cavity may supply power to the fan module at the protruding position, to drive the fan module when the fan module is at the protruding position. When the fan module runs at the protruding position, air intake resistance may be small, air intake volume may be large. In this case, heat dissipation efficiency is high. In addition, when the fan module at the protruding position runs for heat dissipation, space in the fan installation cavity may be increased. This helps reduce a flow voltage drop in the fan installation cavity and reduce flow resistance in the fan installation cavity. In this way, a pressure head of the fan module can be increased.

For a service that requires high performance and heavy load, the fan module runs outside of the housing assembly. When the fan module runs at the protruding position, an air intake vent of the fan module that is located in the fan installation cavity and that is at the insertion position may be exposed to an atmospheric environment. This greatly increases an air intake area of the fan module and reduces air intake flow resistance. In this way, the performance of the fan module can be significantly improved. In this case, a high-load and high-power-consumption application can be supported. After the fan module is retracted back to the insertion position in the housing assembly, the mobile terminal has better overall anti-falling performance.

In some possible implementations, when the fan module moves to any position between the insertion position and the protruding position in the first direction, the fan module is electrically connected to the power supply device through the electrical connection device. In this way, power can be supplied to the fan module at any position between the insertion position and the protruding position, so that the fan module at any position between the insertion position and the protruding position can run for heat dissipation. In addition, this also facilitates controlling the fan module when the fan module moves between the insertion position and the protruding position.

In some possible implementations, the electrical connection device includes an electrical contact terminal securely disposed on the first mechanical part, and the fan module is provided with a first electrical contact portion. The electrical contact terminal includes a second electrical contact portion located in the fan installation cavity and a connection portion located in the device installation cavity, and the connection portion is electrically connected to the power supply device. The first electrical contact portion is configured to be in electrical contact with the second electrical contact portion, to enable the fan module to be electrically connected to the power supply device through the electrical contact terminal. In this way, it is convenient to implement an electrical connection between the fan module and the power supply device. In addition, the electrical connection device has little impact on movement of the fan module.

In some possible implementations, at least one of the second electrical contact portion and the first electrical contact portion is of a strip structure extending in the first direction. When the fan module is at the protruding position, a part of the fan module is located in the fan installation cavity, a part of the fan module protrudes to the outer side of the housing assembly through the fan socket, and at least a part of the first electrical contact portion is located in the fan installation cavity. When the fan module moves to any position between the insertion position and the protruding position in the first direction, the first electrical contact portion is in electrical contact with the second electrical contact portion. In this way, it is convenient to implement the electrical connection between the fan module at any position between the insertion position and the protruding position and the power supply device. In addition, the electrical connection device has little impact on the movement of the fan module.

In some possible implementations, the fan module includes a cover plate and a fan assembly. The cover plate is securely disposed at one end of the fan assembly in the first direction, the fan assembly is inserted into the fan installation cavity through the fan socket, and the cover plate is located on the outer side of the housing assembly. When the fan module is at the insertion position, the cover plate covers an outer surface of the housing assembly, and an orthographic projection of the cover plate on the outer surface of the housing assembly covers an edge of the housing assembly at the fan socket. When the fan module moves between the insertion position and the protruding position in the first direction, at least a part of the fan assembly protrudes to the outer side of the housing assembly through the fan socket, or at least a part of the fan assembly is inserted back into the fan installation cavity through the fan socket. In this way, the cover plate can limit a depth at which the fan module is inserted into the fan installation cavity.

In some possible implementations, the mobile terminal further includes a sealing ring, where the sealing ring is disposed between the cover plate and the outer surface of the housing assembly, and the sealing ring is disposed around the fan socket in a circumferential direction of the fan socket. When the fan module is at the insertion position, the sealing ring is pressed tightly by the cover plate and the outer surface of the housing assembly, and the sealing ring enables the fan module to be hermetically connected to the housing assembly at the fan socket. In this way, when the fan module is at the insertion position, damage to sealing performance of the housing assembly due to provision of the fan socket is not easily caused, so that the mobile terminal has good sealing performance, and overall system reliability is improved.

In some possible implementations, the fan assembly includes a fan base and a fan. The cover plate is securely disposed at one end of the fan base in the first direction, the fan is securely disposed on the fan base, and the fan is disposed on one side of the fan base in a second direction. When the mobile terminal is in the fan locked state, the fan base is locked and fastened to the first mechanical part. When the mobile terminal is in the fan unlocked state, the fan base is unfastened from the first mechanical part; and the fan base may drive the fan to protrude to the outer side of the housing assembly through the fan socket, or the fan base may drive the fan to be inserted back into the fan installation cavity through the fan socket. The second direction is perpendicular to the first direction. In this way, when the fan assembly is partially located in the fan installation cavity, the entire fan can protrude to the outer side of the housing assembly, to facilitate maintenance or repair of the fan. In addition, it is also convenient to dispose a heat dissipation structure and the like on the fan assembly, so that a structure of the fan module is flexible.

In some possible implementations, the fan is detachably connected to the fan base. In this way, the fan can be maintained or repaired after being removed from the fan base, so that the fan is maintained or repaired conveniently.

In some possible implementations, the mobile terminal further includes a heat generation device, where the heat generation device is disposed in the device installation cavity of the housing assembly. The fan module is provided with a module air intake vent and a module air exhaust vent. When the fan module is at the insertion position, the module air intake vent and the module air exhaust vent are located in the fan installation cavity and are in communication with the fan installation cavity. In this way, the fan module can drive air circulation in the device installation cavity and the fan installation cavity, to achieve an effect of temperature equalization. There is no need to dispose an air vent on the outer surface of the mobile terminal, and the appearance of the mobile terminal is not affected.

In some possible implementations, the mobile terminal further includes a heat generation device, where the heat generation device is disposed in the device installation cavity of the housing assembly. The fan installation cavity is isolated from the device installation cavity, and the heat generation device is connected to the first mechanical part through a heat-conducting assembly. The fan module is provided with a module air intake vent and a module air exhaust vent. Both the module air intake vent and the module air exhaust vent are in communication with the outer side of the housing assembly. In this way, heat dissipation performance of the fan module is good. In addition, when the fan module is located at the protruding position, sealing performance of the device installation cavity is not damaged, and the sealing performance of the device installation cavity is good.

When the fan installation cavity and the device installation cavity are isolated from each other, the fan installation cavity and the device installation cavity are located in two sealing waterproof and dustproof systems that are independent of each other. Electrical connection portions and the like of a mainboard, a battery, a chip, and a display are disposed in a sealing waterproof and dustproof system in which the device installation cavity is located, and are physically isolated from the fan installation cavity. An opening in communication with the fan installation cavity does not affect dustproof and waterproof of the device installation cavity. Heat generated by the devices such as the mainboard, the battery, the chip, and the display may be transferred to the first mechanical part through the heat-conducting assembly, and heat is dissipated to an external environment through forced convection of the fan module, so that the mobile terminal can have good heat dissipation performance.

The fan installation cavity and the device installation cavity are located in the two sealing waterproof and dustproof systems that are independent of each other. During routine maintenance and repair of the fan module, or when waterproofness of the fan installation cavity fails, sealing, waterproof, and dustproof performance of the device installation cavity in which the electrical connection portions and the like of the mainboard, the battery, the chip, and the display are located is not affected, and the devices in the device installation cavity can operate properly and reliably. Therefore, there is a strong system fault tolerance design capability and system waterproof and dustproof robustness for the fan module. This facilitates routine maintenance and repair without damage for the fan module.

In some possible implementations, a waterproof and dustproof level of the fan installation cavity is lower than a waterproof and dustproof level of the device installation cavity. In this way, disposing and ventilating of the fan module is easy.

In some possible implementations, a heat dissipation structure is securely connected to the first mechanical part, and the heat dissipation structure is located in the fan installation cavity. In this way, efficiency of heat conduction between the first mechanical part and the heat dissipation structure is high, and efficiency of heat dissipation performed by the fan module for the first mechanical part is high.

In some possible implementations, the fan assembly of the fan module includes a heat dissipation structure, the heat dissipation structure is securely connected to the fan base of the fan assembly, and the heat dissipation structure exchanges heat with the first mechanical part through the fan base. In this way, when the fan module is at the protruding position, at least a part of the heat dissipation structure may be brought to the outer side of the housing assembly, to facilitate thermal performance of the heat dissipation structure.

In some possible implementations, the housing assembly is provided with a first air vent and a second air vent, and both the first air vent and the second air vent communicate the fan installation cavity with the outer side of the housing assembly. When the fan module is at the insertion position, both the module air intake vent and the module air exhaust vent are located in the fan installation cavity, one of the module air intake vent and the module air exhaust vent is in communication with the first air vent through the fan installation cavity, and the other one of the module air intake vent and the module air exhaust vent is in communication with the second air vent. In this way, air intake and air exhaust of the fan module are less limited by a size of the fan module, so that air intake and air exhaust of the fan module with a large air volume can be implemented. The communication between the first air vent and the second air vent, and the module air intake vent and the module air exhaust vent depends on an architecture design. This is not limited in this application.

In some possible implementations, the housing assembly is provided with a first air vent, and the first air vent communicates the fan installation cavity with the outer side of the housing assembly. When the fan module is at the insertion position, one of the module air intake vent and the module air exhaust vent is located in the fan installation cavity and is in communication with the first air vent through the fan installation cavity, and the other one of the module air intake vent and the module air exhaust vent is located at one end that is of the fan module and that faces the outer side of the housing assembly in the first direction. In this way, air can enter and exit the fan installation cavity smoothly, and the heat dissipation efficiency of the fan module is high. In addition, there are few openings on the housing assembly, and impact on an appearance of the housing assembly is small. In addition, openings on the first mechanical part and a requirement for an air duct formed by the first mechanical part may be reduced. This can make a structure of the first mechanical part simple.

In some possible implementations, the cover plate of the fan module is provided with a third air vent and a fourth air vent, one of the third air vent and the fourth air vent is the module air intake vent, and the other one of the third air vent and the fourth air vent is the module air exhaust vent. The fan of the fan module is provided with a fan air intake vent and a fan air exhaust vent, and one of the fan air intake vent and the fan air exhaust vent is in communication with the outer side of the housing assembly through the third air vent. When the fan module is at the insertion position, the other one of the fan air intake vent and the fan air exhaust vent is located in the fan installation cavity, and the fourth air vent communicates the fan installation cavity with the outer side of the housing assembly. In this way, fresh air in the outer side of the housing assembly may be exchanged with air in the fan installation cavity through the third air vent and the fourth air vent, to dissipate heat for the mobile terminal. In addition, the housing assembly may not need to be provided with an air vent, and an appearance of the housing assembly is not affected. In addition, openings on the first mechanical part and a requirement for an air duct formed by the first mechanical part may be reduced. This can make a structure of the first mechanical part simple, and also help reduce a thickness of the mobile terminal.

In some possible implementations, the cover plate of the fan module is provided with a third air vent and a fourth air vent, one of the third air vent and the fourth air vent is the module air intake vent, and the other one of the third air vent and the fourth air vent is the module air exhaust vent. The fan assembly of the fan module further includes a second mechanical part, the second mechanical part is securely disposed on the fan base, the second mechanical part is configured to form a module air duct, and the third air vent communicates the outer side of the housing assembly with the module air duct. The fan of the fan module is provided with a fan air intake vent and a fan air exhaust vent, one of the fan air intake vent and the fan air exhaust vent is in communication with the third air vent through the module air duct, the other one of the fan air intake vent and the fan air exhaust vent is in communication with the outer side of the housing assembly through the fourth air vent, and the heat dissipation structure is disposed in the module air duct. In this way, fresh air in the outer side of the housing assembly may be exchanged with air in the module air duct through the third air vent and the fourth air vent, to dissipate heat for the mobile terminal. In addition, the housing assembly may not need to be provided with an air vent, and an appearance of the housing assembly is not affected. In addition, openings on the first mechanical part and a requirement for an air duct formed by the first mechanical part may be reduced. This can make a structure of the first mechanical part simple, and also help reduce a thickness of the mobile terminal. In addition, when the fan module is at the protruding position, the running fan may continuously dissipate heat.

In some possible implementations, the fan module is a piezoelectric fan module with a small air volume and a high pressure head. A dustproof structure with a waterproof and breathable film is disposed on the module air intake vent and the module air exhaust vent of the fan module. In this way, a thickness of the fan module can be thin, so that the fan module can be easily disposed on the mobile terminal. In addition, air intake and air exhaust directions of a piezoelectric fan are flexible, so that the fan module can be flexibly disposed. In addition, the dustproof structure with the waterproof and breathable film is disposed, so that the piezoelectric fan that is sensitive to dust can run reliably for a long time.

In some possible implementations, the housing assembly includes a housing and a decoration part. The decoration part is securely connected to the housing, and the decoration part protrudes from an outer surface of the housing. The first mechanical part is disposed in the decoration part, the first mechanical part is securely disposed on an inner wall of the decoration part, the first mechanical part and the decoration part enclose the fan installation cavity, and the decoration part is provided with the fan socket. In this way, the fan module may not occupy space in the housing. This facilitates arrangement of a device in the housing, and is especially suitable for an ultra-thin mobile phone like a foldable phone.

In some possible implementations, a locking mechanism is disposed on the first mechanical part. When the mobile terminal is in the fan locked state, the locking mechanism enables the fan module to be locked and fastened to the first mechanical part. When the mobile terminal is in the fan unlocked state, the locking mechanism enables the fan module to be unfastened from the first mechanical part. In this way, the locking mechanism is easy to dispose. In addition, when the fan module protrudes to the outer side of the housing assembly, damage to the locking mechanism due to exposure of the locking mechanism is not easily caused.

In some possible implementations, an anti-detachment structure is securely disposed on the fan module, the anti-detachment structure is located in the fan installation cavity, and the anti-detachment structure is configured to abut against the inner wall of the housing assembly when the fan module is at the protruding position, to limit, from being detached from the housing assembly through the fan socket, the fan module inserted into the fan installation cavity. In this way, the fan module can be kept in a state in which a part of the fan module protrudes from the housing assembly and is connected to the housing assembly, so that heat dissipation on the mobile terminal can be implemented by using the fan module that partially protrudes from the housing assembly.

In some possible implementations, a push-out mechanism is further disposed in the housing assembly. At least a part of the push-out mechanism is located in the fan installation cavity. The push-out mechanism is configured to push a part of the fan module at the insertion position to the outer side of the housing assembly through the fan socket. In this way, the fan module can easily protrude from the fan installation cavity.

According to the mobile terminal provided in embodiments of this application, daily maintenance and simple repair of the fan module can greatly improve reliability and a service life of the fan module that serves as a reliability bottleneck of the entire mobile terminal, support use of the entire mobile terminal with high performance and high system reliability, and remove limitations of a fan service life and fan reliability when the fan module is used in the mobile terminal, to implement active heat dissipation of a mobile phone product that is far better than natural heat dissipation.

### BRIEF DESCRIPTION OF DRAWINGS

FIG. 1 is a diagram of a mobile terminal according to an embodiment of this application;
FIG. 2 is a diagram of another mobile terminal according to an embodiment of this application;
FIG. 3 is a diagram of another mobile terminal according to an embodiment of this application;
FIG. 4 is a diagram of a mobile terminal when a fan module is at an insertion position according to an embodiment of this application;
FIG. 5 is a diagram of the mobile terminal in FIG. 4 when a fan module is at a protruding position;
FIG. 6 is a diagram of another mobile terminal according to an embodiment of this application;
FIG. 7 is a diagram of another mobile terminal according to an embodiment of this application;
FIG. 8 is a diagram of a perspective of another mobile terminal according to an embodiment of this application;
FIG. 9 is a diagram of another perspective of the mobile terminal in FIG. 8;
FIG. 10 is a diagram of a second direction side when a mobile terminal is in a fan locked state and a fan module is at an insertion position according to an embodiment of this application;
FIG. 11 is a diagram of a second direction side when the mobile terminal in FIG. 10 is in a fan unlocked state and a fan module is at a protruding position;
FIG. 12 is another diagram of a second direction side when a mobile terminal is in a fan locked state and a fan module is at an insertion position according to an embodiment of this application;
FIG. 13 is another diagram of a second direction side when a mobile terminal is in a fan locked state and a fan module is at an insertion position according to an embodiment of this application;
FIG. 14 is a diagram of another mobile terminal according to an embodiment of this application;
FIG. 15 is a diagram of another mobile terminal according to an embodiment of this application;
FIG. 16 is a diagram of another mobile terminal according to an embodiment of this application;
FIG. 17 is another diagram of a mobile terminal when a fan module is at an insertion position according to an embodiment of this application;
FIG. 18 is a diagram of the mobile terminal in FIG. 17 when a fan module is at a protruding position;
FIG. 19 is a diagram of a sliding slot of the mobile terminal in FIG. 17 in an extension direction of the sliding slot;
FIG. 20 is a diagram of a joint between a pull rod and a first mechanical part of the mobile terminal in FIG. 17;
FIG. 21 is another diagram of a mobile terminal when a fan module is at a protruding position according to an embodiment of this application;
FIG. 22 is a diagram of another mobile terminal according to an embodiment of this application;
FIG. 23 is a diagram of a mobile terminal before a fan module is inserted into a fan installation cavity according to an embodiment of this application;
FIG. 24 is another diagram of a mobile terminal when a fan module is at an insertion position according to an embodiment of this application;
FIG. 25 is a diagram of the mobile terminal in FIG. 24 when a fan module is at a protruding position;
FIG. 26 is a diagram of a fan module according to an embodiment of this application;
FIG. 27 is a diagram of another mobile terminal according to an embodiment of this application;
FIG. 28 is a diagram of another mobile terminal according to an embodiment of this application;
FIG. 29 is a diagram of another mobile terminal according to an embodiment of this application;
FIG. 30 is a diagram of another mobile terminal according to an embodiment of this application;
FIG. 31 is a diagram of another mobile terminal according to an embodiment of this application;
FIG. 32 is a diagram of another mobile terminal according to an embodiment of this application;
FIG. 33 is a diagram of another mobile terminal according to an embodiment of this application;
FIG. 34 is a diagram of another mobile terminal according to an embodiment of this application;
FIG. 35 is a diagram of another mobile terminal according to an embodiment of this application;
FIG. 36 is a diagram of another mobile terminal according to an embodiment of this application;
FIG. 37 is a diagram of another mobile terminal according to an embodiment of this application;
FIG. 38 is a diagram of another mobile terminal according to an embodiment of this application;
FIG. 39 is a diagram of another mobile terminal according to an embodiment of this application; and
FIG. 40 is a diagram of another mobile terminal according to an embodiment of this application.

### Descriptions of reference numerals:

1: housing assembly; 2: display; 3: mainboard; 4: battery; 5: electrical connection device; 6: chip; 6a: first chip; 6b: second chip;
10: housing; 11: side edge; 12: rear cover; 20: decoration part; 30: first cavity; 31: first device installation cavity; 40: second cavity; 41: second device installation cavity; 50: fan socket; 60: first jack; 61: elastic sealing part;
100: first mechanical part; 110: fan installation cavity; 120: push rod slide; 130: locking ball slide; 140: spring slot; 150: slider slide; 160: pressure plate slide; 170: electrical contact terminal; 171: second electrical contact portion; 172: connection portion;
200: fan module; 210: cover plate; 211: second jack; 220: fan assembly; 221: fan; 222: fan base; 223: locking slot; 224: first electrical contact portion; 225: second mechanical part; 226: module air duct;
300: locking mechanism; 310: lock tongue; 320: connection rod; 330: rotating rod; 340: rotating shaft; 350: first spring; 360: elastic locking assembly; 361: locking ball; 362: third spring; 363: ball base; 370: locking spring; 371: spring arm section; 372: locking section; 380: pull rod; 381: connection section; 382: first insertion section; 383: second insertion section; 384: pressure plate; 385: fourth spring; 390: sliding slot; 391: first slot section; 392: second slot section; 393: third slot section; 394: fourth slot section; 395: fifth slot section; 396: first step structure; 397: second step structure; 398: third step structure; 399: fourth step structure;
400: push-out mechanism; 410: second spring; 420: push plate; 430: electric telescopic rod; 440: slider;
500: unlocking mechanism; 510: push rod; 520: button; 530: electromagnet; 540: magnetic part;
610: first sealing ring; 620: position detection apparatus; 630: anti-detachment structure; 640: heat dissipation structure; 650: dustproof structure with a waterproof and breathable film;
700: heat-conducting assembly; 710: thermal interface material; 720: heat-conducting plate; 730: shielding cover;
810: first air vent; 820: second air vent; 830: third air vent; 840: fourth air vent;
x: first direction; y: second direction; and z: third direction.

### DESCRIPTION OF EMBODIMENTS

Terms used in implementations of this application are merely intended to describe specific embodiments of this application, but not to limit this application. The following describes implementations of embodiments of this application in detail with reference to the accompanying drawings.

Embodiments of this application provide a mobile terminal. The mobile terminal may include but is not limited to a mobile phone, a tablet computer, an ultra-mobile personal computer (ultra-mobile personal computer, UMPC), a handheld computer, a walkie-talkie, a netbook, a point of sale (Point of sale, POS) machine, a personal digital assistant (personal digital assistant, PDA), a wearable device, a virtual reality device, or the like. In embodiments of this application, an example in which the mobile terminal is the mobile phone is used for description.

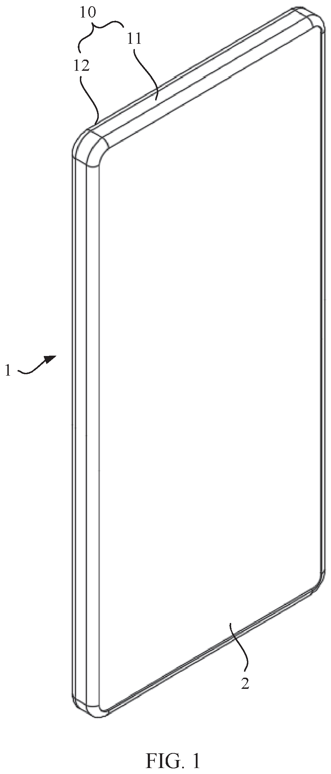

FIG. 1 is a diagram of a mobile terminal according to an embodiment of this application.

As shown in FIG. 1, in this embodiment of this application, the mobile terminal may include a housing assembly 1 and a display 2. The display 2 is disposed on the housing assembly 1, and the housing assembly 1 is provided with a cavity for disposing a device.

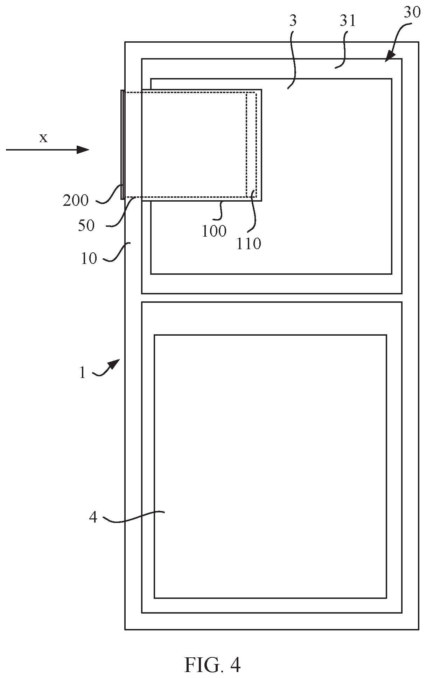

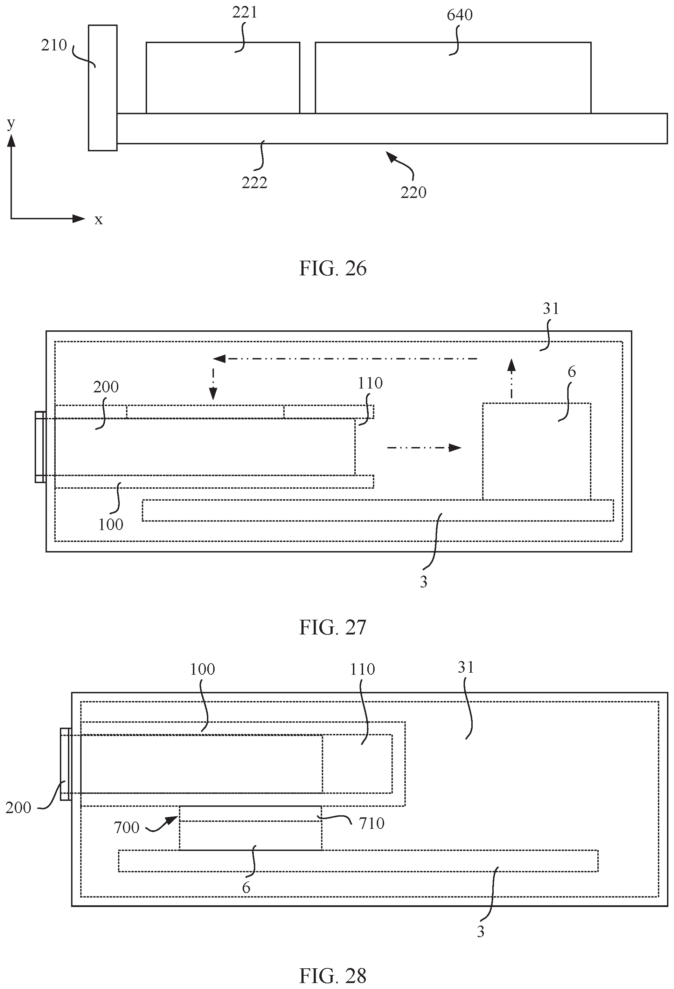

The housing assembly 1 includes a housing 10, the display 2 is disposed on a side of the housing 10 in a thickness direction, the housing 10 may be provided with a first cavity 30, the display 2 may be configured to cover an opening on a side of the first cavity 30 in the thickness direction of the housing 10, and the first cavity 30 may be configured to dispose devices such as a mainboard 3 (as shown in FIG. 4), a battery 4 (as shown in FIG. 4), and a chip 6 (as shown in FIG. 27).

The housing 10 may include a middle frame (not shown), a side edge 11, and a rear cover 12. The side edge 11 is securely disposed on an edge of the middle frame, the display 2 is disposed on one side of the side edge 11 in a thickness direction of the middle frame, the rear cover 12 covers the other side of the side edge 11 in the thickness direction of the middle frame, and the side edge 11 and the rear cover 12 are configured to enclose the first cavity 30 (as shown in FIG. 4).

In some examples, the middle frame and the side edge 11 are of an integrated structure.

In some other examples, the middle frame and the side edge 11 are of a split structure, and the side edge 11 may be connected to the middle frame through nano molding.

For example, the display 2 may be bonded to the side edge 11.

For example, the rear cover 12 may be disposed on the side edge 11 in at least one manner of bonding, fastener connection, clamping, and the like.

In some examples, the mobile terminal may be a non-foldable device. For example, the mobile terminal may be a bar-type mobile phone. In this case, the housing assembly 1 includes one housing 10.

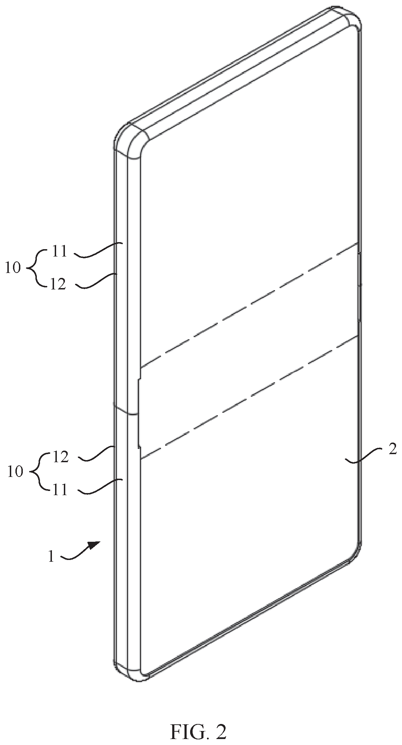

FIG. 2 is a diagram of another mobile terminal according to an embodiment of this application.

As shown in FIG. 2, in some other examples, the mobile terminal may be a foldable device. For example, the mobile terminal may be a foldable mobile phone. A housing assembly 1 may include a plurality of housings 10, a rotating shaft mechanism (not shown) is disposed between two adjacent housings 10, and two adjacent housings 10 are rotatably connected through a rotating shaft mechanism between the two adjacent housings. Specifically, middle frames 11 of two adjacent housings 10 may be rotatably connected through a rotating shaft mechanism between the two adjacent housings 10. When the mobile terminal is the foldable device, a display 2 may be a flexible display, and the flexible display may cover the plurality of housings 10. When the foldable device is in an unfolded state, the flexible display may be located on a same side in a thickness direction of the plurality of covered housings 10.

When the mobile terminal is the foldable device, each housing 10 may be provided with a first cavity 30. A mainboard 3 and a battery 4 may be respectively disposed in first cavities 30 of two different housings 10.

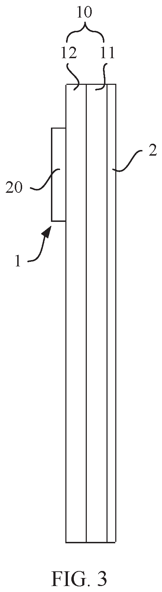

FIG. 3 is a diagram of another mobile terminal according to an embodiment of this application.

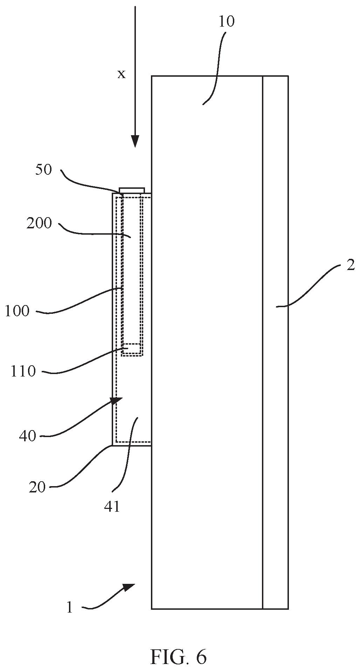

As shown in FIG. 3, in some examples, a housing assembly 1 further includes a decoration part 20 (deco), and the decoration part 20 is securely connected to a side that is of a housing 10 and that faces away from a display 2. Specifically, the decoration part 20 may be securely connected to a rear cover 12. The decoration part 20 protrudes from an outer surface of the housing 10 on which the decoration part 20 is located. The decoration part 20 is provided with a second cavity 40 (as shown in FIG. 6). The second cavity 40 may be configured to dispose a camera, a display device (for example, a time display device or an ultraviolet radiation display device), and the like. The second cavity 40 in the decoration part 20 may be in communication with a first cavity 30 in the housing 10 on which the decoration part 20 is located.

When the housing assembly 1 includes a plurality of housings 10, one of the housings 10 may be securely connected to the decoration part 20.

To improve heat dissipation performance of the mobile terminal, the mobile terminal further includes a fan module 200 (as shown in FIG. 4) configured to perform active air-cooling heat dissipation, and the fan module 200 may be disposed in the housing assembly.

After the mobile terminal is used for a period of time, the fan module 200 is prone to problems such as dust accumulation and damage. When the fan module 200 has the problems such as dust accumulation and damage, routine maintenance (for example, dust cleaning) or repair needs to be performed on the fan module 200.

In a related technology, the fan module is disposed in the first cavity of the housing. When the fan module is repaired, the display or the rear cover needs to be first removed from the side edge to expose the fan module, and then the fan module can be repaired. However, after the display or the rear cover is removed from the side edge, sealing between the side edge and the display or the rear cover is easily damaged. After the fan module is repaired, the side edge and the display or the rear cover usually need to be sealed again. In this case, repair costs of the fan module are high, and operation difficulty is high. This may easily cause scrapping of the entire mobile terminal. In addition, when the display or the rear cover is removed to repair the fan module located in the first cavity, other components or devices of the mobile terminal, such as the housing assembly, a side button, the display, and the battery, are easily damaged. This causes scrapping of the other components or devices. Costs of the fan module are far lower than costs of devices such as the display, the chip, and the battery. Repair costs of the devices such as the display, the chip, and the battery are high after the devices are scrapped. For the mobile terminal in the related technology, it is inconvenient to repair the fan module, and it is difficult to perform routine maintenance.

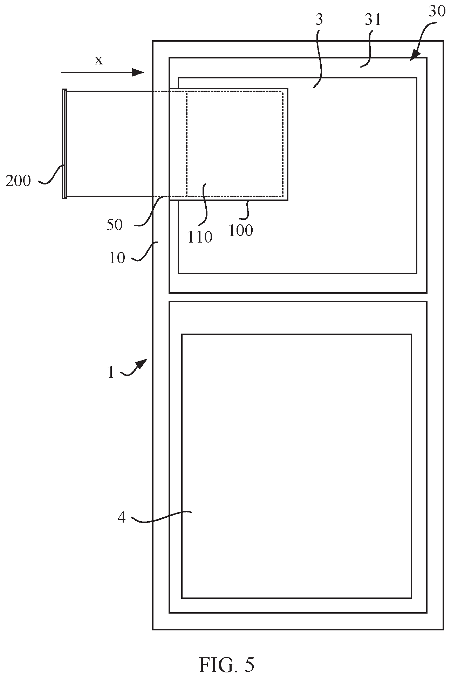

FIG. 4 is a diagram of a mobile terminal when a fan module is at an insertion position according to an embodiment of this application. FIG. 5 is a diagram of the mobile terminal in FIG. 4 when a fan module is at a protruding position. In the figures, an x direction is a first direction, and the first direction is a plugging direction of the fan module 200.

As shown in FIG. 4, based on this, in this embodiment of this application, the mobile terminal further includes a first mechanical part 100. The first mechanical part 100 is securely disposed on an inner wall of a housing assembly 1. The first mechanical part 100 and the housing assembly 1 enclose a fan installation cavity 110. The housing assembly 1 is provided with a fan socket 50 communicating the fan installation cavity 110 with an outer side of the housing assembly 1, and the fan module 200 is inserted into the fan installation cavity 110 through the fan socket 50.

The mobile terminal has a fan locked state and a fan unlocked state. When the mobile terminal is in the fan locked state, the fan module 200 is locked and fastened to the first mechanical part 100. When the mobile terminal is in the fan unlocked state, the fan module 200 is unfastened from the first mechanical part 100, and the fan module 200 is movable between the insertion position and the protruding position in the first direction, to enable at least a part of the fan module 200 to protrude to the outer side of the housing assembly 1 through the fan socket 50, or at least a part of the fan module 200 to be inserted back into the fan installation cavity 110 through the fan socket 50. Specifically, when the fan module 200 moves from the insertion position to the protruding position, at least a part of the fan module 200 protrudes to the outer side of the housing assembly 1 through the fan socket 50. When the fan module 200 moves from the protruding position to the insertion position, at least a part of the fan module 200 is inserted back into the fan installation cavity 110 through the fan socket 50.

In this way, when the fan module 200 needs to be maintained or repaired, at least a part of the fan module 200 can protrude to the outer side of the housing assembly 1 through the fan socket 50, to facilitate maintenance such as dust removal and cleaning, or repair work like repair or replacement on the fan module 200. The fan module 200 may be inserted back into the fan installation cavity 110 through the fan socket 50 after being maintained or repaired. A display 2, a side edge 11, and a rear cover 12 do not need to be removed for repairing the fan module 200, and sealing between the display 2, the side edge 11, and the rear cover 12 is not easily damaged. After the fan module 200 is maintained or repaired, the display 2, the side edge 11, and the rear cover 12 do not need to be sealed again. Maintenance or repair costs of the fan module 200 are low, operation difficulty is low, and scrapping of the entire mobile terminal is difficult. In addition, when the fan module 200 protruding to the outer side of the housing assembly 1 is repaired, a repair tool does not need to protrude into the housing assembly 1. It is not easy to damage another component or device of the mobile terminal, and the repair costs are low. According to the mobile terminal provided in embodiments of this application, it is convenient to maintain or repair the fan module 200. In addition, the first mechanical part 100 is disposed to form the fan installation cavity 110 for the fan module 200 to be inserted, so that the fan module 200 is securely fastened and securely connected to the housing assembly 1. When the mobile terminal is in the fan locked state, the fan module 200 may be securely fastened to the housing assembly 1. This helps maintain performance of the fan module 200. When the mobile terminal is in the fan unlocked state, the fan module 200 may move stably in the first direction. This is easy to operate. Protruding and inserting processes of the fan module 200 are not easy to cause damage to the entire mobile terminal.

The first direction may be a length direction, a width direction, or a thickness direction of the mobile terminal.

When the mobile terminal is a foldable device, the length direction of the mobile terminal is a length direction of the mobile terminal when the mobile terminal is in an unfolded state, the width direction of the mobile terminal is a width direction of the mobile terminal when the mobile terminal is in the unfolded state, and the thickness direction of the mobile terminal is a thickness direction of the mobile terminal when the mobile terminal is in the unfolded state.

When the mobile terminal is in the fan unlocked state, the fan module 200 may be in a sliding fit with a cavity wall of the fan installation cavity 110.

In some examples, when the fan module 200 is at the insertion position, the fan module 200 may be completely accommodated in the fan installation cavity 110.

In some other examples, when the fan module 200 is at the insertion position, the fan module 200 is partially accommodated in the fan installation cavity 110, and partially protrudes to the outer side of the housing assembly 1 through the fan socket 50. In this way, the fan module 200 at the insertion position is easily pulled out through the fan socket 50.

The protruding position may be determined based on an actual requirement. For example, when the fan module 200 is at the protruding position, one third, one half, two thirds, three fourths, four fifths, or an entirety of the fan module 200 in the first direction may protrude to the outer side of the housing assembly 1.

A first cavity 30 includes a first device installation cavity 31. Devices such as a mainboard 3, a battery 4, and a chip 6 of the mobile terminal are disposed in the first device installation cavity 31. The battery 4 may be electrically connected to the mainboard 3. The chip 6 may be disposed on the mainboard 3 and electrically connected to the mainboard 3. The display 2 may be configured to cover an opening on a side of the first device installation cavity 31 in a thickness direction of a housing 10.

For example, one or more chips 6 may be disposed on the mainboard 3.

For example, a system on a chip (system on a chip, SoC), a power management (power management unit, PMU) chip, and the like may be disposed on the mainboard 3.

A device that generates a large amount of heat during operation may be referred to as a heat generation device. The mobile terminal includes the heat generation device, and the heat generation device may include but is not limited to a mainboard, a battery, a chip, a camera, and the like.

In some examples, the first mechanical part 100 is disposed in the housing 10. Specifically, the first mechanical part 100 is located in the first cavity 30, the first mechanical part 100 is securely disposed on an inner wall of the housing 10, the first mechanical part 100 and the housing 10 enclose the fan installation cavity 110, and the housing 10 is provided with the fan socket 50. In this case, the first cavity 30 includes the fan installation cavity 110 and the first device installation cavity 31, and the first device installation cavity 31 is located outside the fan installation cavity 110.

In this way, a distance between the fan module 200 and the heat generation device disposed in the first device installation cavity 31 is short, so that a heat dissipation effect of the fan module 200 can be good.

When the first mechanical part 100 is securely disposed on the inner wall of the housing 10, the first mechanical part 100 may be securely connected to at least one of the side edge 11 and the rear cover 12.

FIG. 6 is a diagram of another mobile terminal according to an embodiment of this application.

As shown in FIG. 6, in an example in which a housing assembly 1 includes a decoration part 20, a second cavity 40 may include a second device installation cavity 41, a device like a camera may be disposed in the second device installation cavity 41, the second device installation cavity 41 may be in communication with a first device installation cavity 31, and the device like the camera disposed in the second device installation cavity 41 may be electrically connected to a mainboard 3.

In some examples in which the housing assembly 1 includes the decoration part 20, a first mechanical part 100 may be disposed in the decoration part 20. Specifically, the first mechanical part 100 is located in the second cavity 40, the first mechanical part 100 is securely disposed on an inner wall of the decoration part 20, the first mechanical part 100 and the decoration part 20 enclose a fan installation cavity 110, and the decoration part 20 is provided with a fan socket 50.

In this way, a fan module 200 may not occupy space in a housing 10. This facilitates arrangement of a device in the housing 10. In addition, the fan module 200 needs sufficient thick space and air intake space to achieve high performance. This directly conflicts with a light and thin design of the mobile terminal, especially an appearance requirement of a foldable device. By disposing the first mechanical part 100 and the fan module 200 in the decoration part 20, the conflict between an ultra-thin appearance and high-performance application of the fan module 200 can be resolved.

In some examples in which the housing assembly 1 includes the decoration part 20, the second cavity 40 includes the fan installation cavity 110 and the second device installation cavity 41, and the second device installation cavity 41 is located outside the fan installation cavity 110.

In some other examples in which the housing assembly 1 includes the decoration part 20, the decoration part 20 may alternatively be a decoration part 20 that is independently configured to dispose the fan module 200. In other words, other devices such as a camera and a display device may not be disposed in the second cavity 40.

In some examples, an orientation of the fan socket 50 may be perpendicular to a thickness direction of the mobile terminal, that is, a first direction may be perpendicular to the thickness direction of the mobile terminal. For example, the first direction may be a length direction or a width direction of the mobile terminal.

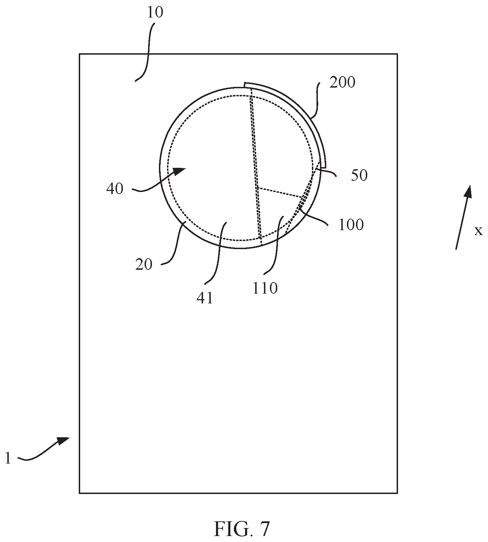

FIG. 7 is a diagram of another mobile terminal according to an embodiment of this application.

As shown in FIG. 7, in some examples, an orientation of a fan socket 50 may be perpendicular to a thickness direction of the mobile terminal, and tilts to a length direction and a width direction of the mobile terminal. In other words, a first direction may be perpendicular to the thickness direction of the mobile terminal, and tilts to the length direction and the width direction of the mobile terminal.

In some examples, a size of a cross section of one end that is of a fan installation cavity 110 and that is away from the fan socket 50 is less than a size of the fan socket 50. In this way, a depth at which a fan module 200 is inserted into the fan installation cavity 110 may be limited by using a cavity wall of the fan installation cavity 110. For example, a size of a cross section of the fan installation cavity 110 may gradually decrease from one end connected to the fan socket 50 to the end away from the fan socket 50, and a shape of the fan module 200 matches a shape of the fan installation cavity 110. The cross section of the fan installation cavity 110 is a cross section of the fan installation cavity 110 perpendicular to the first direction.

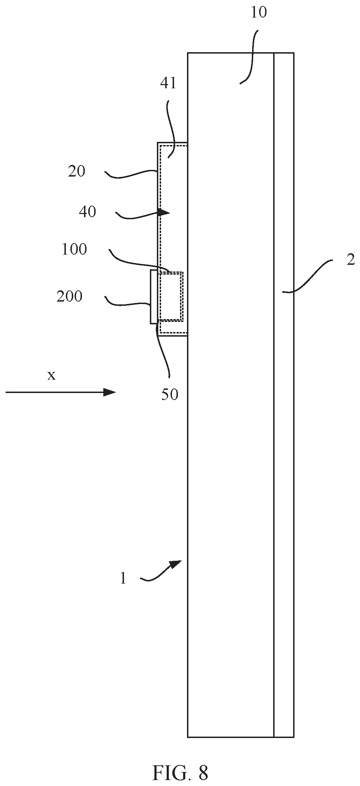

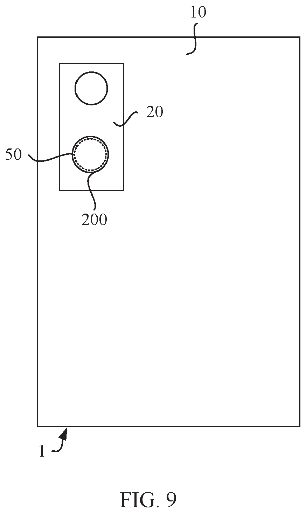

FIG. 8 is a diagram of a perspective of another mobile terminal according to an embodiment of this application. FIG. 9 is a diagram of another perspective of the mobile terminal in FIG. 8. After a fan module 200 is removed in an x direction in FIG. 8 and FIG. 9, an exposed surface that is of a first mechanical part 100 and that is configured to be in contact with the fan module 200 is an inner wall of the first mechanical part 100.

As shown in FIG. 8 and FIG. 9, in some examples, an orientation of a fan socket 50 may be a thickness direction of the mobile terminal, that is, a first direction is the thickness direction of the mobile terminal.

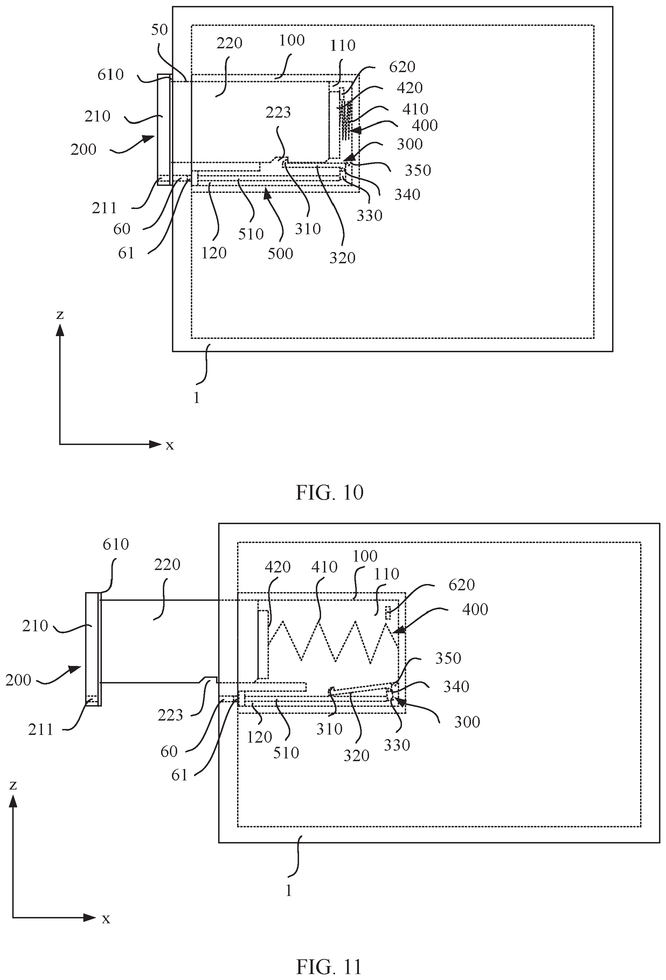

FIG. 10 is a diagram of a second direction side when a mobile terminal is in a fan locked state and a fan module is at an insertion position according to an embodiment of this application. FIG. 11 is a diagram of a second direction side when the mobile terminal in FIG. 10 is in a fan unlocked state and the fan module is at a protruding position. In the figures, a z direction is a third direction, a second direction is perpendicular to a first direction, the third direction is perpendicular to the first direction, and the second direction is perpendicular to the third direction.

As shown in FIG. 10 and FIG. 11, in some possible implementations, a locking mechanism 300 is disposed on a first mechanical part 100. When the mobile terminal is in the fan locked state, the locking mechanism 300 enables the fan module 200 to be locked and fastened to the first mechanical part 100. When the mobile terminal is in the fan unlocked state, the locking mechanism 300 enables the fan module 200 to be unfastened from the first mechanical part 100.

In this way, the locking mechanism 300 is easy to dispose. In addition, when the fan module 200 protrudes to an outer side of a housing assembly 1, damage to the locking mechanism 300 due to exposure of the locking mechanism 300 is not easily caused.

In some examples, the locking mechanism 300 includes a lock tongue 310, a connection rod 320, a rotating rod 330, a rotating shaft 340, and a first spring 350. One end of the connection rod 320 is securely connected to the lock tongue 310, the other end of the connection rod 320 is securely connected to one end of the rotating rod 330, the rotating shaft 340 is disposed between two ends of the rotating rod 330, the two ends of the rotating shaft 340 extend in the second direction, the rotating rod 330 is rotatably connected to the first mechanical part 100 through the rotating shaft 340, and the rotating rod 330 is connected to the first mechanical part 100 through the first spring 350. A side surface of the fan module 200 in the third direction is provided with a locking slot 223 in a fit with the lock tongue 310. When the mobile terminal is in the fan locked state, the lock tongue 310 is located at a locked position and inserted into the locking slot 223, so that the fan module 200 is locked and fastened to the first mechanical part 100. When the mobile terminal is in the fan unlocked state, the lock tongue 310 rotates around the rotating shaft 340 to an unlocked position outside the locking slot 223, so that the fan module 200 is unfastened from the first mechanical part 100. The first spring 350 is configured to drive, to rotate to the locked position, the lock tongue 310 located at the unlocked position.

The fan module 200 includes an insertion end (not shown), and the insertion end is one end on a side that is of the fan module 200 and that faces a fan installation cavity 110 and is away from a fan socket 50.

For example, in a process in which the fan module 200 moves from the protruding position to the insertion position, a part that is of the insertion end and that is configured to abut against the lock tongue 310 located at the locked position is an oblique surface, so that the lock tongue 310 is pushed to rotate from the locked position to the unlocked position. In this way, when the locking slot 223 moves to the lock tongue 310, the lock tongue 310 may be inserted into the locking slot 223.

For example, in a process in which the fan module 200 moves from the protruding position to the insertion position, a part that is of the lock tongue 310 at the locked position and that is configured to abut against the insertion end is an arc surface, so that the insertion end pushes, in the process in which the fan module 200 moves from the protruding position to the insertion position, the lock tongue 310 to rotate from the locked position to the unlocked position.

In some examples in which the locking mechanism 300 is disposed on the first mechanical part 100, an unlocking mechanism 500 is further disposed on the first mechanical part 100. The unlocking mechanism 500 is in transmission connection with the locking mechanism 300. The unlocking mechanism 500 is configured to switch the mobile terminal from the fan locked state to the fan unlocked state after receiving an unlock signal.

In some examples in which the locking mechanism 300 includes the lock tongue 310, the connection rod 320, the rotating rod 330, the rotating shaft 340, and the first spring 350, the unlocking mechanism 500 may include a push rod 510 extending in the first direction at two ends, and the first mechanical part 100 is provided with a push rod slide 120 extending in the first direction at two ends. The push rod 510 is slidably assembled in the push rod slide 120. The housing assembly 1 is provided with a first jack 60 communicating the push rod slide 120 with the outer side of the housing assembly 1. One end of the push rod 510 is configured to abut against one end that is of the rotating rod 330 and that is away from the connection rod 320, and the other end of the push rod 510 is opposite to the first jack 60. The first jack 60 may be configured for a pin to pass through. After passing through the first jack 60, the pin may push the push rod 510 to slide, to exert an unlock signal to the push rod 510. The push rod 510 pushed by the pin may push the rotating rod 330 to rotate, to rotate the lock tongue 310 from the locked position to the unlocked position. In this way, the mobile terminal can be switched from the fan locked state to the fan unlocked state.

For example, an elastic sealing part 61 is disposed in the first jack 60, the elastic sealing part 61 is provided with a communication hole, and the communication hole may be configured for the pin to pass through. When no pin passes through the communication hole, the elastic sealing part 61 presses a hole wall of the communication hole tightly, to seal the communication hole. When the pin is inserted into the first jack 60, the elastic sealing part 61 may deform under an acting force of the pin, to open the communication hole, so that the pin can pass through the communication hole. When the pin passes through the communication hole, the hole wall of the communication hole and a side wall of the pin are pressed tightly, so that the pin is sealed with the hole wall of the communication hole. In this way, damage to sealing performance of the housing assembly 1 due to provision of the first jack 60 is not easily caused.

In some possible implementations, a push-out mechanism 400 is further disposed in the housing assembly 1. At least a part of the push-out mechanism 400 is located in the fan installation cavity 110. The push-out mechanism 400 is configured to push a part of the fan module 200 at the insertion position to the outer side of the housing assembly 1 through the fan socket 50.

In this way, the fan module 200 can protrude from the fan installation cavity 110. The fan module 200 is pushed out by using the push-out mechanism 400, and the fan module 200 may not need to be pulled out by hand, and has good automatic push-out user experience and reliability.

For example, the push-out mechanism 400 may include a second spring 410. One end of the second spring 410 is connected to the first mechanical part 100, and the other end of the second spring 410 is configured to abut against the fan module 200. Specifically, the second spring 410 is configured to abut against the insertion end. When the mobile terminal is in the fan locked state, the second spring 410 is in a compressed state. When the mobile terminal is in the fan unlocked state, an elastic recovery force generated by the second spring 410 is used to push a part of the fan module 200 at the insertion position to the outer side of the housing assembly 1 through the fan socket 50.

For example, the push-out mechanism 400 may further include a push plate 420. One end of the second spring 410 is connected to the first mechanical part 100, the other end of the second spring 410 is connected to the push plate 420, and the second spring 410 is configured to abut against the fan module 200 through the push plate 420, so that the second spring 410 pushes the fan module 200 stably.

In some possible implementations, a position detection apparatus 620 is further disposed in the fan installation cavity 110, and the position detection apparatus 620 is configured to detect whether the fan module 200 is at the insertion position. The position detection apparatus 620 may be electrically connected to a mainboard 3 through a cable, and may be further electrically connected, through the mainboard 3, to a controller (not shown) electrically connected to the mainboard 3. The controller may be configured to: obtain detection information obtained by the position detection apparatus 620, and determine, based on the detection information, whether the fan module 200 is at the insertion position. The controller may be further configured to: when the fan module 200 is not at the insertion position, send a control instruction instructing that the fan module 200 is not at the insertion position. The control instruction may be used to control an audible and visual alarm, a display 2, and the like to give an alert.

For example, the position detection apparatus 620 may include but is not limited to a distance sensor, a pressure sensor, and the like.

When the position detection apparatus 620 is the distance sensor, the position detection apparatus 620 may be configured to detect a distance between the fan module 200 and the position detection apparatus 620.

When the position detection apparatus 620 is the pressure sensor, the fan module 200 at the insertion position is configured to exert pressure to the pressure sensor. Specifically, when the push-out mechanism 400 includes the push plate 420, the fan module 200 at the insertion position may be configured to exert pressure to the pressure sensor through the push plate 420. In the first direction, the push plate 420 is located between the fan module 200 and the pressure sensor. When the fan module 200 is at the insertion position, one side of the push plate 420 abuts against the fan module 200, and the other side of the push plate 420 abuts against the pressure sensor.

In some possible implementations, the fan module 200 includes a cover plate 210 and a fan assembly 220, and the fan assembly 220 may be configured to perform active air-cooling heat dissipation on the mobile terminal. The cover plate 210 is securely disposed at one end of the fan assembly 220 in the first direction, the fan assembly 220 is inserted into the fan installation cavity 110 through the fan socket 50, and the cover plate 210 is located on the outer side of the housing assembly 1. When the fan module 200 is at the insertion position, the cover plate 210 covers an outer surface of the housing assembly 1, and an orthographic projection of the cover plate 210 on the outer surface of the housing assembly 1 covers an edge of the housing assembly 1 at the fan socket 50. When the fan module 200 moves between the insertion position and the protruding position in the first direction, at least a part of the fan assembly 220 protrudes to the outer side of the housing assembly 1 through the fan socket 50, or at least a part of the fan assembly 220 is inserted back into the fan installation cavity 110 through the fan socket 50.

In this way, the cover plate 210 can limit a depth at which the fan module 200 is inserted into the fan installation cavity 110.

In some examples in which the housing assembly 1 is provided with the first jack 60 for the pin to be inserted, the cover plate 210 is provided with a second jack 211 opposite to the first jack 60, and the pin may pass through the second jack 211 and the first jack 60 and then protrude into the push rod slide 120, to push the push rod 510.

In some possible implementations, the mobile terminal further includes a first sealing ring 610. The first sealing ring 610 is disposed between the cover plate 210 and the outer surface of the housing assembly 1, and the first sealing ring 610 is disposed around the fan socket 50 in a circumferential direction of the fan socket 50. When the fan module 200 is at the insertion position, the first sealing ring 610 is pressed tightly by the cover plate 210 and the outer surface of the housing assembly 1, and the first sealing ring 610 enables the fan module 200 to be hermetically connected to the housing assembly 1 at the fan socket 50.

In this way, when the fan module 200 is at the insertion position, damage to the sealing performance of the housing assembly 1 due to provision of the fan socket 50 is not easily caused, so that the mobile terminal has good sealing performance.

The fan module 200 may be equipped with a waterproof and dustproof assembly.

In some examples, the waterproof and dustproof assembly of the fan module 200 may include the first sealing ring 610, and the first sealing ring 610 may be securely disposed on the cover plate 210.

In this way, the fan assembly 220 is easily plugged and unplugged at the fan socket 50.

In some other examples, the first sealing ring 610 may be securely disposed on the housing assembly 1.

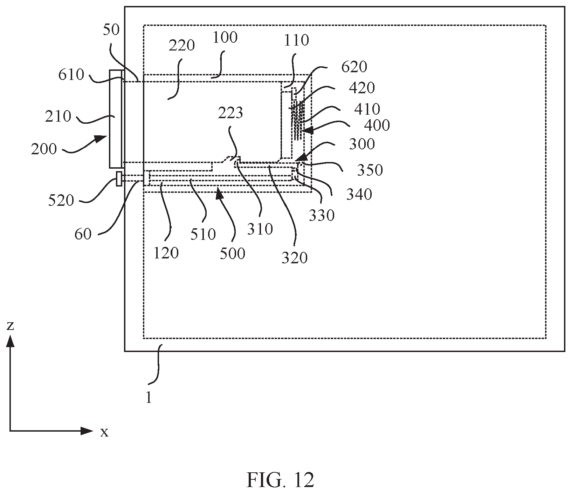

FIG. 12 is another diagram of a second direction side when a mobile terminal is in a fan locked state and a fan module is at an insertion position according to an embodiment of this application.

As shown in FIG. 12, in some other examples in which a locking mechanism 300 includes a lock tongue 310, a connection rod 320, a rotating rod 330, a rotating shaft 340, and a first spring 350, an unlocking mechanism 500 includes a push rod 510 extending in a first direction at two ends, and a first mechanical part 100 is provided with a push rod slide 120 extending in the first direction at two ends. The push rod 510 is slidably assembled in the push rod slide 120. A housing assembly 1 is provided with a first jack 60 communicating the push rod slide 120 with an outer side of the housing assembly 1. The unlocking mechanism 500 further includes a button 520 disposed in the first jack 60. One end of the push rod 510 is configured to abut against one end that is of the rotating rod 330 and that is away from the connection rod 320, and the other end of the push rod 510 is securely connected to the button 520. A user may exert an unlock signal to the button 520 by pressing the button 520. The pressed button 520 may push the push rod 510 to slide, and the push rod 510 pushed by the button 520 may push the rotating rod 330 to rotate, to rotate the lock tongue 310 from a locked position to an unlocked position. In this way, the mobile terminal can be switched from the fan locked state to a fan unlocked state.

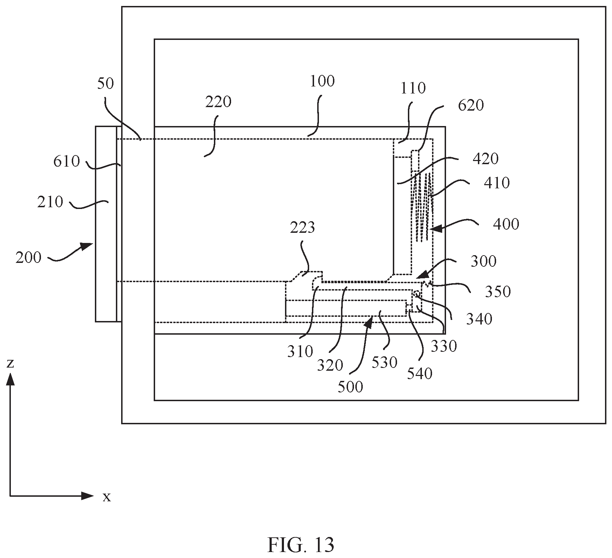

FIG. 13 is another diagram of a second direction side when a mobile terminal is in a fan locked state and a fan module is at an insertion position according to an embodiment of this application.

As shown in FIG. 13, in still some other examples in which a locking mechanism 300 includes a lock tongue 310, a connection rod 320, a rotating rod 330, a rotating shaft 340, and a first spring 350, an unlocking mechanism 500 includes an electromagnet 530 and a magnetic part 540. The electromagnet 530 is securely connected to a first mechanical part 100, and the magnetic part 540 is securely disposed at one end that is of the rotating rod 330 and that is away from the connection rod 320. When the mobile terminal is in the fan 221 locked state, the electromagnet 530 is powered off and is attracted to the magnetic part 540. A user exerts an unlock signal to the electromagnet 530 by powering on the electromagnet 530. The powered-on electromagnet 530 generates a magnetic repulsion force that pushes the magnetic part 540 away, and the magnetic part 540 pushed away by the magnetic repulsion force generated by the electromagnet 530 drives the rotating rod 330 to rotate, to rotate the lock tongue 310 from a locked position to an unlocked position. In this way, the mobile terminal can be switched from the fan locked state to a fan unlocked state.

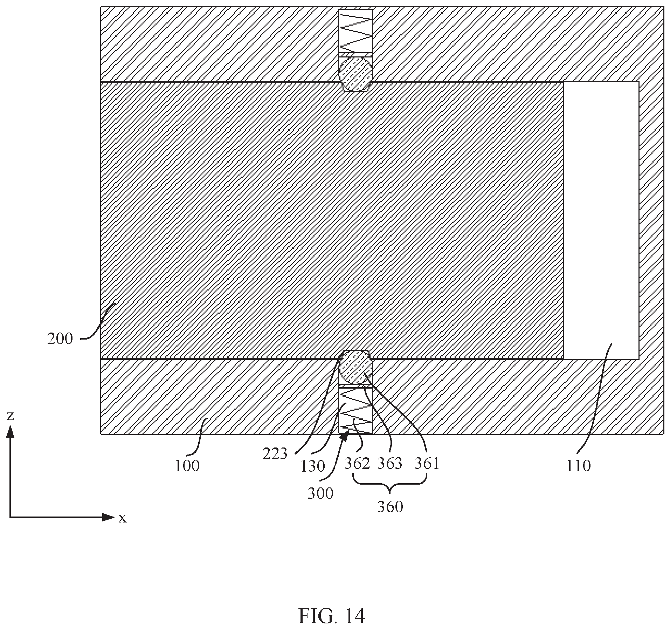

FIG. 14 is a diagram of another mobile terminal according to an embodiment of this application.

As shown in FIG. 14, in some examples, a locking mechanism 300 is an elastic locking mechanism 300, and the locking mechanism 300 is configured to deform under an action of an unlocking force, so that the mobile terminal is switched from a fan locked state to a fan unlocked state. The unlocking force is an acting force exerted, to the locking mechanism 300, by a fan module 200 moving in a first direction, and the unlocking force is greater than an elastic recovery force generated by the locking mechanism 300 when the locking mechanism 300 deforms to unlock the fan module 200 from the first mechanical part 100. In this way, when the fan module 200 is plugged or unplugged, a dedicated unlocking operation is not needed, so that the fan module 200 can be plugged or unplugged conveniently.

In some examples in which the locking mechanism 300 is the elastic locking mechanism 300, the locking mechanism 300 includes an elastic locking assembly 360, and the first mechanical part 100 is provided with a locking ball slide 130 corresponding to the elastic locking assembly 360. One end of the locking ball slide 130 is in communication with a fan installation cavity 110, and the other end of the locking ball slide 130 is of a sealed structure. The elastic locking assembly 360 includes a third spring 362 and a locking ball 361. The locking ball 361 of the elastic locking assembly 360 is slidably assembled in the corresponding locking ball slide 130. One end of the third spring 362 of the elastic locking assembly 360 abuts against one end that is of the corresponding locking ball slide 130 and that is away from the fan installation cavity 110, and the other end abuts against the locking ball 361. A limiting ring (not shown) is disposed at the end of that is of the locking ball slide 130 and that is in communication with the fan installation cavity 110. A part of the locking ball 361 may protrude into the fan installation cavity 110 through the limiting ring, and the limiting ring is configured to limit the locking ball 361 from being detached from the locking ball slide 130. The elastic locking assembly 360 is disposed on at least one side of the fan installation cavity 110 in a third direction, and a side surface of the fan module 200 in the third direction is provided with a locking slot 223 corresponding to the elastic locking assembly 360.

When the mobile terminal is in the fan locked state, a part of the locking ball 361 of the elastic locking assembly 360 is located in the fan installation cavity 110, and protrudes into the corresponding locking slot 223, so that the fan module 200 is locked and fastened to the first mechanical part 100. The locking ball 361 compresses the third spring 362 under an action of an unlocking force, so that at least a part of the locking ball 361 is retracted back into the corresponding locking ball slide 130, to move out of the corresponding locking slot 223, so that the mobile terminal is switched from the fan locked state to the fan unlocked state. In a process in which the fan module 200 moves from a protruding position to an insertion position, the third spring 362 is first compressed, so that at least a part of the locking ball 361 is retracted back into the corresponding locking ball slide 130. After the fan module 200 moves to the insertion position, a part of the locking ball 361 moves into the fan installation cavity 110 under an action of an elastic recovery force of the third spring 362, and protrudes into the corresponding locking slot 223.

In some examples, the elastic locking assembly 360 further includes a ball base 363. The ball base 363 is disposed between the third spring 362 and the locking ball 361. The ball base 363 may be securely connected to the third spring 362. The ball base 363 is in a sliding fit with the locking ball slide 130. The third spring 362 abuts against the locking ball 361 through the ball base 363. In this way, the locking ball 361 can slide stably in the locking ball slide 130.

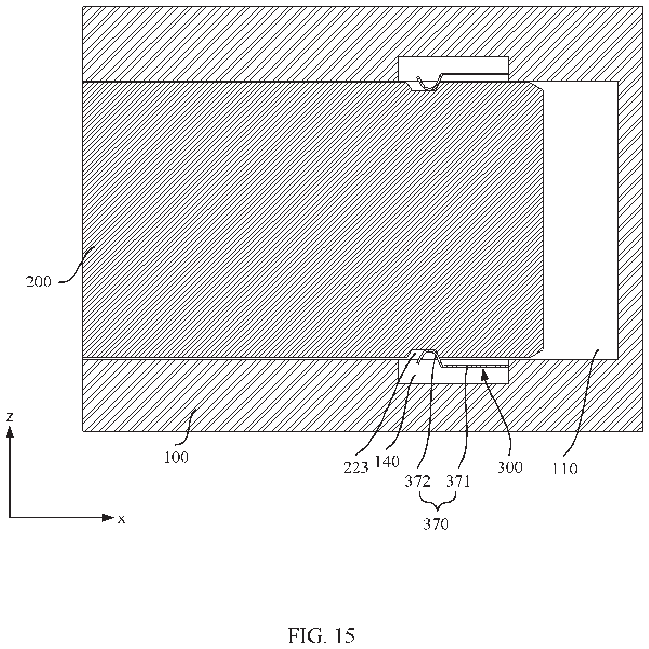

FIG. 15 is a diagram of another mobile terminal according to an embodiment of this application.

As shown in FIG. 15, in some examples in which a locking mechanism 300 is an elastic locking mechanism 300, the locking mechanism 300 includes a locking spring 370, and an inner wall of a first mechanical part 100 is provided with a spring slot 140 corresponding to the locking spring 370. The locking spring 370 includes a spring arm section 371 and a locking section 372. The spring arm section 371 is located in the corresponding spring slot 140. One end of the spring arm section 371 is securely connected to a slot wall on a side that is of the corresponding spring slot 140 and that is away from a fan socket 50 in a first direction, and the other end of the spring arm section 371 is securely connected to the locking section 372. The locking spring 370 is disposed on at least one side of a fan installation cavity 110 in a third direction, and a side surface of a fan module 200 in the third direction is provided with a locking slot 223 corresponding to the locking spring 370.

When the mobile terminal is in a fan locked state, a part of the locking section 372 of the locking spring 370 is located in the fan installation cavity 110 and protrudes into the corresponding locking slot 223, so that the fan module 200 is locked and fastened to the first mechanical part 100. The locking section 372 causes the spring arm section 371 to deform in the third direction in a direction away from the fan module 200 under an action of an unlocking force, to move the locking section 372 out of the corresponding locking slot 223, so that the mobile terminal is switched from the fan locked state to a fan unlocked state. In a process in which the fan module 200 moves from a protruding position to an insertion position, the spring arm section 371 first deforms in the third direction in the direction away from the fan module 200, so that at least a part of the locking section 372 is retracted back into the corresponding spring slot 140. After the fan module 200 moves to the insertion position, a part of the locking section 372 moves to the fan installation cavity 110 under an action of an elastic recovery force of the spring arm section 371, and protrudes into the corresponding locking slot 223.

For example, a side that is of the locking section 372 and that is close to the fan socket 50 and a side that is of the locking section 372 and that is away from the fan socket 50 each are of an oblique surface structure, so that the locking section 372 moves in the third direction under abutting of the fan module 200 that moves in the first direction.

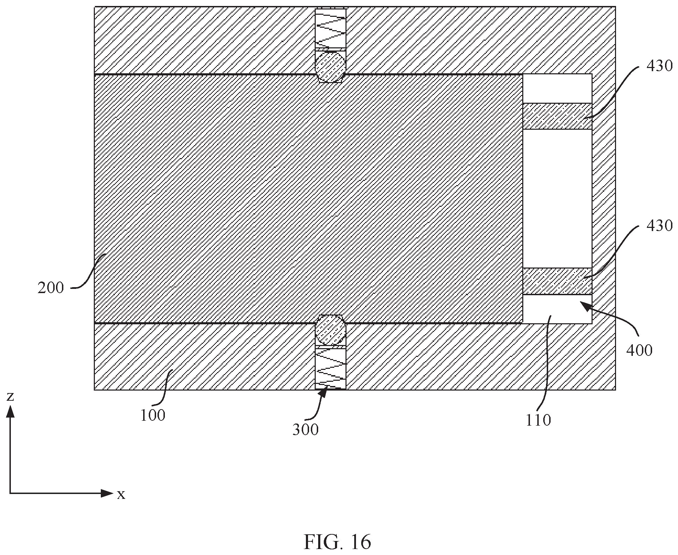

FIG. 16 is a diagram of another mobile terminal according to an embodiment of this application.

In some examples in which a locking mechanism 300 is an elastic locking mechanism 300, a push-out mechanism 400 includes an electric telescopic rod 430. Two ends of the electric telescopic rod 430 extend in a first direction, one end of the electric telescopic rod 430 is securely connected to a first mechanical part 100, and the other end of the electric telescopic rod 430 is configured to abut against an insertion end of a fan module 200. The electric telescopic rod 430 may be electrically connected to a mainboard 3. After receiving a push-out signal, the electric telescopic rod 430 extends to exert an unlocking force to the locking mechanism 300, and push a part of the fan module 200 to an outer side of a housing assembly 1.

The electric telescopic rod 430 may be electrically connected to a controller through the mainboard 3, and is controlled by the controller.

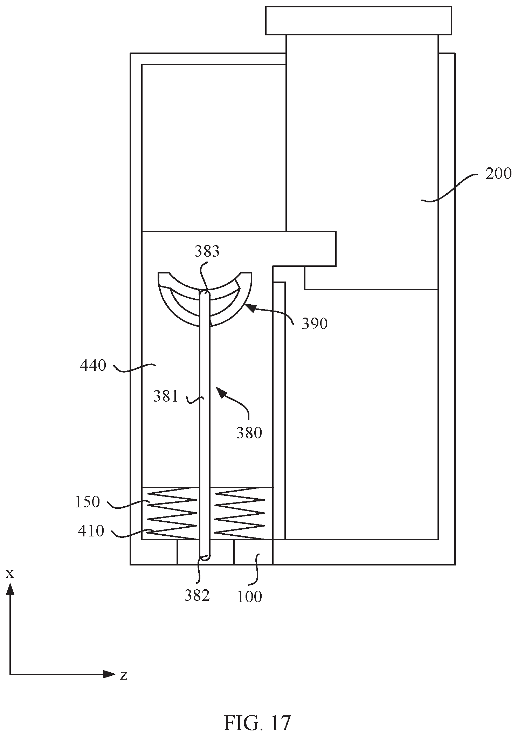

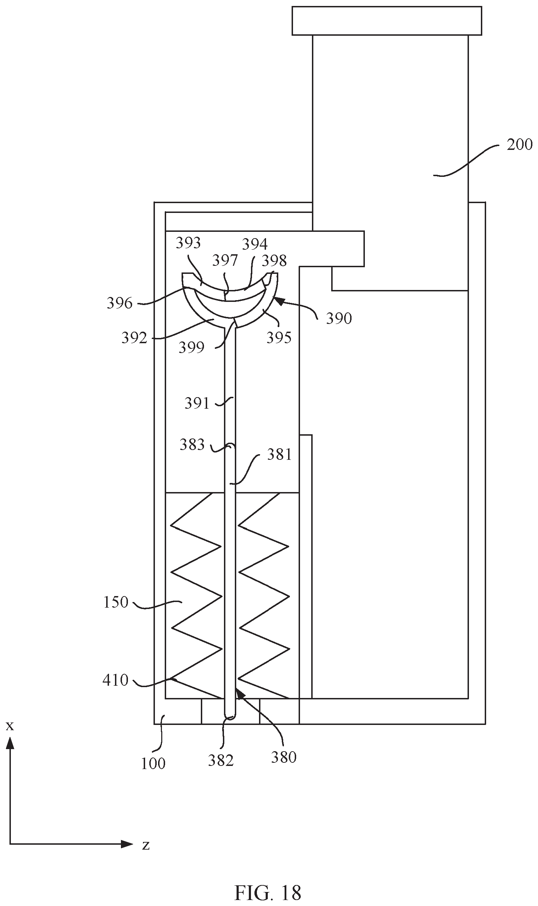

FIG. 17 is another diagram of a mobile terminal when a fan module is at an insertion position according to an embodiment of this application. FIG. 18 is a diagram of the mobile terminal in FIG. 17 when a fan module is at a protruding position.

As shown in FIG. 17 and FIG. 18, in some examples, a first mechanical part 100 is provided with a slider slide 150 extending in a first direction at two ends, and a push-out mechanism 400 includes a slider 440 and a second spring 410. The slider 440 is in a sliding fit with the slider slide 150, two ends of the second spring 410 extend in the first direction, one end that is of the second spring 410 and that is close to a fan socket 50 abuts against the slider 440, one end that is of the second spring 410 and that is away from the fan socket 50 abuts against the first mechanical part 100, and the slider 440 is securely connected to the fan module 200.

A locking mechanism 300 includes a pull rod 380. The pull rod 380 includes a connection section 381, a first insertion section 382, and a second insertion section 383. Two ends of the connection section 381 are spaced apart in the first direction. One end of the connection section 381 is securely connected to one end of the first insertion section 382, and the other end of the connection section 381 is securely connected to one end of the second insertion section 383. The first insertion section 382 and the second insertion section 383 each are a straight rod extending in a second direction at two ends. A surface on a side of the slider 440 in the second direction is provided with a sliding slot 390, one end that is of the second insertion section 383 and that is away from the connection section 381 is inserted into the sliding slot 390, and is in a sliding fit with the sliding slot 390. The second insertion section 383 may slide in the sliding slot 390.

The sliding slot 390 includes a first slot section 391, a second slot section 392, a third slot section 393, a fourth slot section 394, and a fifth slot section 395. The first slot section 391 is a straight slot extending in the first direction at two ends. One end that is of the first slot section 391 and that is away from the fan socket 50 is a sealed end. The second slot section 392, the third slot section 393, the fourth slot section 394, and the fifth slot section 395 are all arc-shaped slots.

In the first direction, one end that is of the second slot section 392 and that is away from the fan socket 50 is connected to one end that is of the first slot section 391 and that is close to the fan socket 50, one end that is of the second slot section 392 and that is close to the fan socket 50 is connected to one end that is of the third slot section 393 and that is close to the fan socket 50, one end that is of the third slot section 393 and that is away from the fan socket 50 is connected to one end that is of the fourth slot section 394 and that is away from the fan socket 50, one end that is of the fourth slot section 394 and that is close to the fan socket 50 is connected to one end that is of the fifth slot section 395 and that is close to the fan socket 50, and one end that is of the fifth slot section 395 and that is away from the fan socket 50 is connected to the end that is of the first slot section 391 and that is close to the fan socket 50. Sides that are of the second slot section 392, the third slot section 393, the fourth slot section 394, and the fifth slot section 395 and that face the fan socket 50 in the first direction are all of concave arc structures.

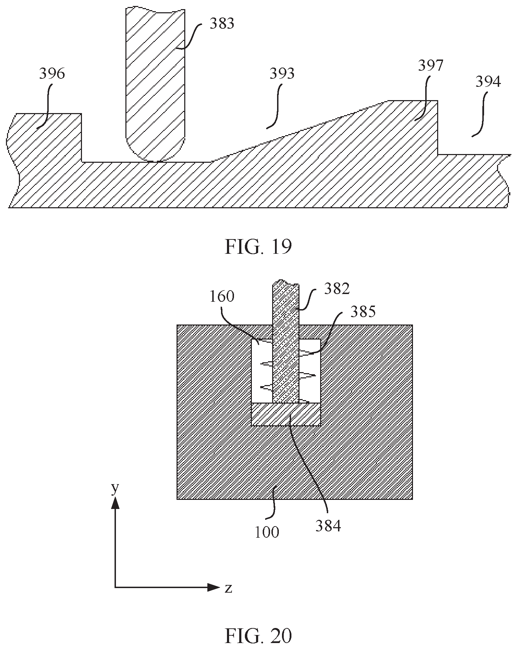

FIG. 19 is a diagram of a sliding slot of the mobile terminal in FIG. 17 in an extension direction of the sliding slot.

As shown in FIG. 19, with reference to FIG. 17 and FIG. 18: A first step structure 396 is formed at a joint between the second slot section 392 and the third slot section 393, and the first step structure 396 is configured to prevent, from sliding to the second slot section 392, the second insertion section 383 that slides into the third slot section 393. A second step structure 397 is formed at a joint between the third slot section 393 and the fourth slot section 394, and the second step structure 397 is configured to prevent, from sliding to the third slot section 393, the second insertion section 383 that slides into the fourth slot section 394. A third step structure 398 is formed at a joint between the fourth slot section 394 and the fifth slot section 395, and the third step structure 398 is configured to prevent, from sliding to the fourth slot section 394, the second insertion section 383 that slides into the fifth slot section 395. A fourth step structure 399 is formed at a joint between the fifth slot section 395 and the first slot section 391, and the fourth step structure 399 is configured to prevent, from sliding to the fifth slot section 395, the second insertion section 383 that slides into the first slot section 391 and the second slot section 392.

The second slot section 392 is provided with an oblique surface structure configured to enable the second insertion section 383 to slide, to the first step structure 396, from the end that is of the second slot section 392 and that is connected to the first slot section 391; the third slot section 393 is provided with an oblique surface structure configured to enable the second insertion section 383 to slide, to the second step structure 397, from the end that is of the third slot section 393 and that is connected to the second slot section 392; the fourth slot section 394 is provided with an oblique surface structure configured to enable the second insertion section 383 to slide, to the third step structure 398, from the end that is of the fourth slot section 394 and that is connected to the third slot section 393; and the fifth slot section 395 is provided with an oblique surface structure configured to enable the second insertion section 383 to slide, to the fourth step structure 399, from the end that is of the fifth slot section 395 and that is connected to the fourth slot section 394.

FIG. 20 is a diagram of a joint between a pull rod and a first mechanical part of the mobile terminal in FIG. 17. In the figure, a y direction is a second direction.

As shown in FIG. 20, with reference to FIG. 17 to FIG. 19, the first mechanical part 100 is provided with a pressure plate slide 160 extending in the second direction at two ends, a pressure plate 384 is slidably assembled in the pressure plate slide 160, the first mechanical part 100 is provided with a sliding hole in communication with the pressure plate slide 160, the first insertion section 382 is inserted into the sliding hole, the first insertion section 382 may slide relative to the first mechanical part 100 in the second direction, and the first insertion section 382 is rotatably connected to the first mechanical part 100. One end that is of the first insertion section 382 and that is away from the connection section 381 is located in the pressure plate slide 160 and is connected to the pressure plate 384. When the second insertion section 383 slides in an oblique surface structure in the sliding slot 390, the first insertion section 382 drives the pressure plate 384 to slide in the pressure plate channel 160. A fourth spring 385 is disposed in the pressure plate slide 160, and one end of the fourth spring 385 abuts against one side that is of the pressure plate 384 and that faces the sliding hole, and the other end of the fourth spring 385 abuts against the first mechanical part 100. The fourth spring 385 is configured to keep the end that is of the second insertion section 383 and that is away from the connection section 381 in contact with a slot bottom of the sliding slot 390.

When the mobile terminal is in a fan locked state, the second insertion section 383 is located in the fourth slot section 394, and is located at the end that is of the fourth slot section 394 and that is connected to the third slot section 393. The fan module 200 is locked and fastened to the first mechanical part 100 by using the pull rod 380 and the slider 440.

When the fan module 200 needs to move from the insertion position to the protruding position, the fan module 200 may be pressed in the first direction to drive the slider 440 to move. Because of blocking of the second step structure 397 and the third step structure 398, the second insertion section 383 slides into the fifth slot section 395 along the fourth slot section 394 and slides to the first slot section 391, so that the pull rod 380 and the slider 440 are unlocked, and the third spring 362 pushes the slider 440 to drive the fan module 200 to protrude out. The second insertion section 383 may slide to the end that is of the first slot section 391 and that is away from the fan socket 50 along the fifth slot section 395 and the first slot section 391.

When the fan module 200 needs to move from the protruding position to the insertion position, the fan module 200 may be pressed in the first direction to drive the slider 440 to move. Because of blocking of the fourth step structure 399 and the first step structure 396, the second insertion section 383 slides into the third slot section 393 along the first slot section 391 and the second slot section 392, and moves, along the third slot section 393, to the end that is of the fourth slot section 394 and that is connected to the third slot section 393. In this way, the fan module 200 may be locked and fastened at the insertion position.

For example, the end that is of the second insertion section 383 and that is away from the connection section 381 may be of a ball head structure, so that the second insertion section 383 slides in an oblique surface.

In some other possible implementations, the locking mechanism 300 is disposed on the fan module 200. When the mobile terminal is in the fan locked state, the locking mechanism 300 enables the fan module 200 to be locked and fastened to the first mechanical part 100. When the mobile terminal is in the fan unlocked state, the locking mechanism 300 enables the fan module 200 to be unfastened from the first mechanical part 100.

In some examples, when the mobile terminal is in the fan unlocked state, the fan module 200 may be completely pulled out from the fan socket 50. In other words, the fan module 200 may be detached from the housing assembly 1.

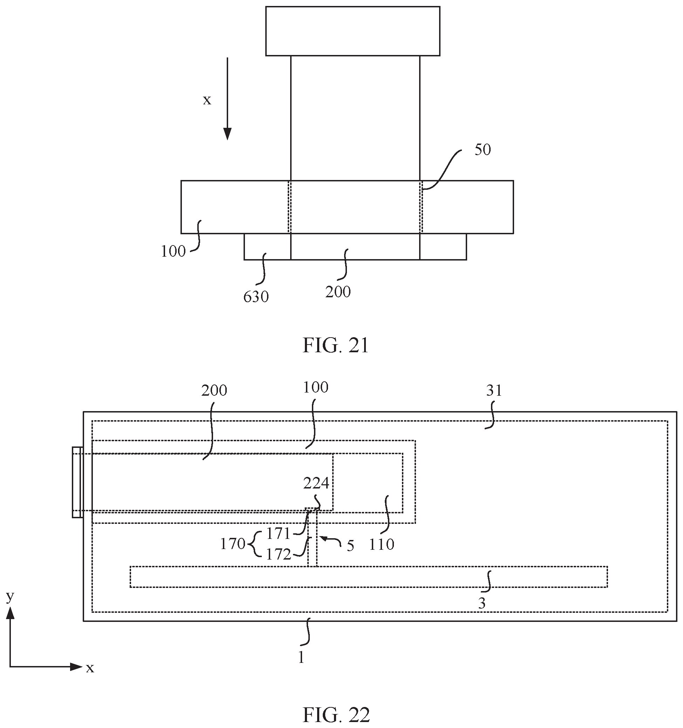

FIG. 21 is another diagram of a mobile terminal when a fan module is at a protruding position according to an embodiment of this application.

As shown in FIG. 21, in some other examples, when the mobile terminal is in a fan unlocked state, the fan module 200 cannot be completely pulled out from a fan socket 50. In other words, the fan module 200 cannot be detached from a housing assembly 1, and a part of the fan module 200 is always located in a fan installation cavity 110. Specifically, an anti-detachment structure 630 may be securely disposed on the fan module 200, and the anti-detachment structure 630 is located in the fan installation cavity 110. The anti-detachment structure 630 is configured to abut against an inner wall of the housing assembly 1 when the fan module 200 is at the protruding position, to limit, from being detached from the housing assembly 1 through the fan socket 50, the fan module 200 inserted into the fan installation cavity 110.

In this way, the fan module 200 can be kept in a state in which a part of the fan module protrudes from the housing assembly 1 and is connected to the housing assembly 1, so that heat dissipation on the mobile terminal can be implemented by using the fan module 200 that partially protrudes from the housing assembly 1.

For example, a cavity wall of the fan installation cavity 110 is provided with a sliding slot structure (not shown) configured for the anti-detachment structure 630 to slide in a first direction. The anti-detachment structure 630 is inserted into the sliding slot structure.

FIG. 22 is a diagram of another mobile terminal according to an embodiment of this application.

As shown in FIG. 22, the mobile terminal further includes a power supply device and an electrical connection device 5. The power supply device is disposed in a first device installation cavity 31, a part of the electrical connection device 5 is located in the first device installation cavity 31, and a part of the electrical connection device 5 is located in a fan installation cavity 110.

In some examples, when a fan module 200 is at an insertion position, the fan module 200 is electrically connected to the power supply device through the electrical connection device 5.

In this way, the power supply device disposed in the first device installation cavity 31 may supply power to the fan module 200 at the insertion position, to drive the fan module 200 when the fan module 200 is at the insertion position. When the fan module 200 runs at the insertion position, overall anti-falling performance of the mobile terminal is good, and an appearance of the mobile terminal does not change.

In some examples, when the fan module 200 is at a protruding position, the fan module 200 is electrically connected to the power supply device through the electrical connection device 5.

In this way, the power supply device disposed in the first device installation cavity 31 may supply power to the fan module 200 at the protruding position, to drive the fan module 200 when the fan module 200 is at the insertion position. When the fan module 200 runs at the protruding position, air intake resistance may be small, air intake volume may be large. In this case, heat dissipation efficiency is high. In addition, when the fan module 200 at the protruding position runs for heat dissipation, space in the fan installation cavity 110 may be increased. This helps reduce a flow voltage drop in the fan installation cavity 110 and reduce flow resistance in the fan installation cavity 110. In this way, a pressure head of the fan module 200 can be increased.

For a service that requires high performance and heavy load, the fan module 200 may eject a housing assembly 1 manually or eject the housing assembly 1 automatically based on software temperature reporting. When the fan module 200 is at the protruding position, the fan module 200 may run, so that an air intake vent of the fan module 200 that is located in the fan installation cavity 110 and that is at the insertion position can be exposed to an atmospheric environment. This greatly increases an air intake area of the fan module 200 and reduces air intake flow resistance. In this way, performance of the fan module 200 can be significantly improved. In this case, high-load and high-power-consumption application can be supported. After the fan module 200 is retracted back to the insertion position in the housing assembly 1, the mobile terminal has better overall anti-falling performance.

The power supply device may include but is not limited to a mainboard 3, a battery 4, a controller, and the like.

For example, the fan module 200 may be electrically connected to the mainboard 3 through the electrical connection device 5, the battery 4 may supply power to the fan module 200 by using the mainboard 3, and the controller may control the fan module 200 by using the mainboard 3. In this way, power supply and control of the fan module 200 are convenient.

In some possible implementations, the electrical connection device 5 includes an electrical contact terminal 170 securely disposed on a first mechanical part 100, and the fan module 200 is provided with a first electrical contact portion 224. The electrical contact terminal 170 includes a second electrical contact portion 171 located in the fan installation cavity 110 and a connection portion 172 located in the first device installation cavity 31, and the connection portion 172 is electrically connected to the power supply device. The first electrical contact portion 224 is configured to be in electrical contact with the second electrical contact portion 171, to enable the fan module 200 to be electrically connected to the power supply device through the electrical contact terminal 170.

In this way, it is convenient to implement an electrical connection between the fan module 200 and the power supply device. In addition, the electrical connection device 5 has little impact on movement of the fan module 200.

In some examples, when the fan module 200 is at the insertion position, the first electrical contact portion 224 is located in the fan installation cavity 110 and is in electrical contact with the second electrical contact portion 171, and the fan module 200 is electrically connected to the power supply device through the electrical contact terminal 170.

In this way, it is convenient to implement the electrical connection between the fan module 200 and the power supply device when the fan module 200 is at the insertion position.

In some examples, when the fan module 200 is at the protruding position, the first electrical contact portion 224 is located in the fan installation cavity 110 and is in electrical contact with the second electrical contact portion 171, and the fan module 200 is electrically connected to the power supply device through the electrical contact terminal 170.

In this way, it is convenient to implement the electrical connection between the fan module 200 and the power supply device when the fan module 200 is at the protruding position.

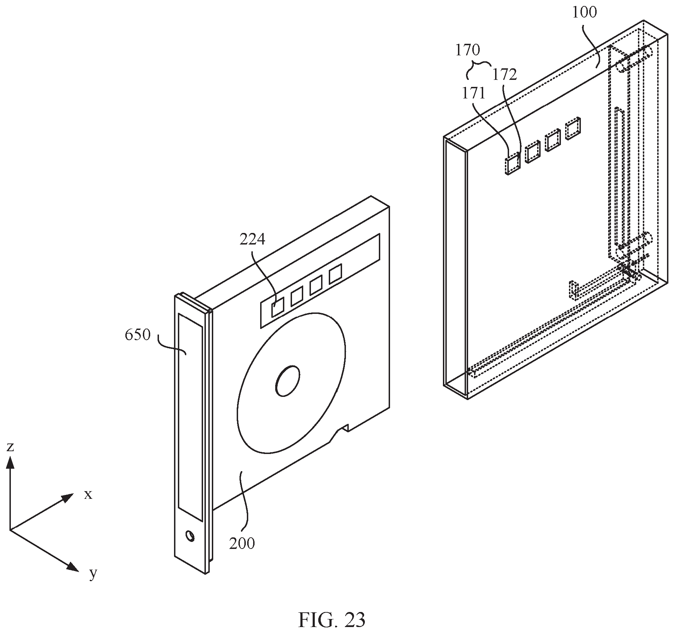

FIG. 23 is a diagram of a mobile terminal before a fan module is inserted into a fan installation cavity according to an embodiment of this application.

As shown in FIG. 23, in some examples, a first electrical contact portion 224 is located on a surface of a side of a fan module 200 in a second direction, the first electrical contact portion 224 may be a conductive contact piece structure, and a second electrical contact portion 171 may be a conductive contact piece structure.

In some other examples, an insertion end of the fan module 200 is provided with a plug port, the first electrical contact portion 224 is a conductive contact piece structure disposed in the plug port, and the second electrical contact portion 171 is a conductive pin structure disposed on a side that is of the fan installation cavity 110 and that is opposite to the fan socket 50. When the fan module 200 is at an insertion position, a conductive pin is inserted into the plug port and is in electrical contact with the conductive contact piece structure in the plug port.

In some examples, a second sealing ring (not shown) is disposed at an edge of the plug port, and a waterproof and dustproof assembly of the fan module 200 may include the second sealing ring. When the fan module 200 is at the insertion position, the second sealing ring is pressed tightly by the fan module 200 and a first mechanical part 100. The second sealing ring enables the fan module 200 to be hermetically connected to the first mechanical part 100 at the plug port, so that the conductive contact piece structure in the plug port and the conductive pin in electrical contact are in sealed space.

For example, an electrical connection device 5 includes a plurality of electrical contact terminals 170. A plurality of first electrical contact portions 224 in one-to-one correspondence with the plurality of electrical contact terminals 170 are disposed on the fan module 200. The plurality of electrical contact terminals 170 include a positive terminal, a negative terminal, and a signal terminal. The plurality of first electrical contact portions 224 include a positive electrical contact portion, a negative electrical contact portion, and a signal electrical contact portion corresponding to the signal terminal. The positive terminal is configured to be in electrical contact with the positive electrical contact portion. The negative terminal is configured to be in electrical contact with the negative electrical contact portion. The signal terminal is configured to be in electrical contact with the correspond signal electrical contact portion.

A distance between the positive terminal and the negative terminal may be greater than or equal to 1 mm. For example, the distance between the positive terminal and the negative terminal may be greater than or equal to 5 mm, to reduce a risk of a short circuit between the positive terminal and the negative terminal.

A distance between the positive electric contact portion and the negative electric contact portion may be greater than or equal to 1 mm. For example, the distance between the positive electric contact portion and the negative electric contact portion may be greater than or equal to 5 mm.

In some examples, a controller may be configured to: obtain impedance between the positive terminal and the negative terminal, and determine, based on the impedance between the positive terminal and the negative terminal, whether liquid enters the fan installation cavity 110. The controller may be further configured to: when it is determined that liquid enters the fan installation cavity 110, send a control instruction instructing to stop supplying power to the fan module 200 or reduce a voltage of supplying power to the fan module 200. For example, the control instruction may be used to increase an impedance threshold that affects a function.

In some examples, surfaces of the electrical contact terminal 170 and the first electrical contact portion 224 have anti-corrosion coatings, to improve service lives of the electrical contact terminal 170 and the first electrical contact portion 224.

In some examples, a protection circuit is disposed between the power supply device and at least one of the positive terminal and the negative terminal. The protection circuit is configured to perform a current limiting or voltage limiting function when an electrical connection between the positive terminal and the negative terminal is abnormal, to avoid the short circuit between the positive terminal and the negative terminal.

The positive terminal and the negative terminal may be electrically connected to the controller. The controller may be configured to obtain a voltage or a current at the positive terminal and the negative terminal. The controller is further configured to send, when the voltage or the current at the positive terminal and the negative terminal is not in a preset range, instructions instructing an abnormal electrical connection, to remind a user to clean and repair.

In some possible implementations, when the fan module 200 is not at the insertion position, an electrical connection between the fan module 200 and the electrical connection device 5 is disconnected. In this case, the controller may determine, depending on whether the fan module 200 is powered on, whether the fan module 200 is at the insertion position. When the fan module 200 is not at the insertion position, the fan module 200 cannot run.

In some possible implementations, when the fan module 200 is not at a protruding position, an electrical connection between the fan module 200 and the electrical connection device 5 is disconnected. In this case, the controller may determine, depending on whether the fan module 200 is powered on, whether the fan module 200 is at the protruding position. When the fan module 200 is not at the protruding position, the fan module 200 cannot run.

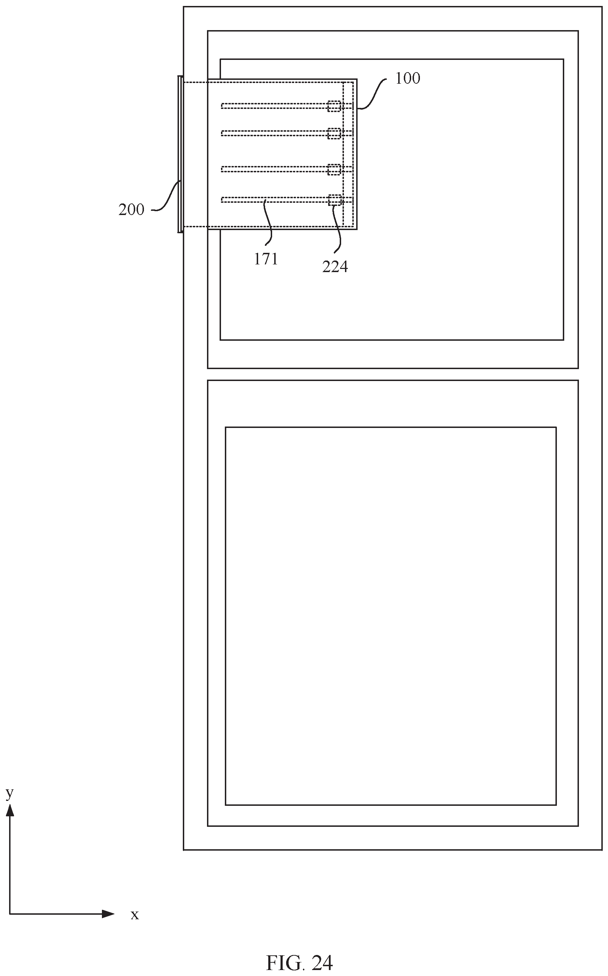

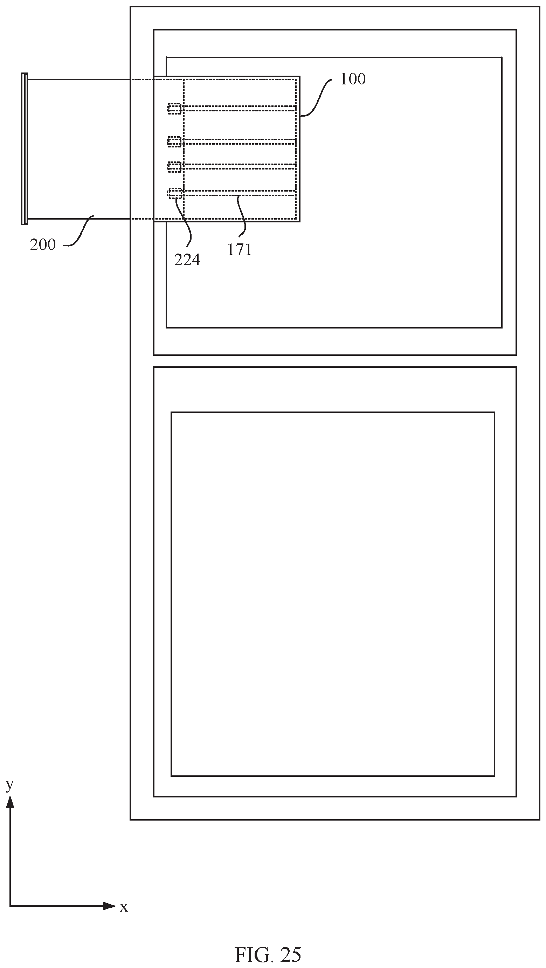

FIG. 24 is another diagram of a mobile terminal when a fan module is at an insertion position according to an embodiment of this application. FIG. 25 is a diagram of the mobile terminal in FIG. 24 when a fan module is at a protruding position.

As shown in FIG. 24 and FIG. 25, in some other possible implementations, when the fan module 200 moves to any position between the insertion position and the protruding position in a first direction, the fan module 200 is electrically connected to a power supply device through an electrical connection device 5.

In this way, power can be supplied to the fan module 200 at any position between the insertion position and the protruding position, so that the fan module 200 at any position between the insertion position and the protruding position can run for heat dissipation. In addition, this also facilitates controlling the fan module 200 when the fan module 200 moves between the insertion position and the protruding position.

In an example in which the fan module 200 is electrically connected to the power supply device through the electrical connection device 5 when the fan module 200 moves to any position between the insertion position and the protruding position in the first direction, the fan module 200 and a fan installation cavity 110 may form a variable air duct, and the controller may control the fan module 200 at the protruding position to run or stop running.

For example, when the fan module 200 is at the protruding position, the controller may send a control instruction instructing a display 2 to display whether to control the fan module 200 to continue running. After receiving a signal indicating to control the fan module 200 to run, the controller controls the fan module 200 to continue running. After receiving a signal indicating to stop the fan module 200 from running, the controller controls the fan module 200 to stop running.

In some possible implementations, at least one of a second electrical contact portion 171 and a first electrical contact portion 224 is of a strip structure extending in the first direction. When the fan module 200 is at the protruding position, a part of the fan module 200 is located in the fan installation cavity 110, a part of the fan module 200 protrudes to an outer side of a housing assembly 1 through a fan socket 50, and at least a part of the first electrical contact portion 224 is located in the fan installation cavity 110. When the fan module 200 moves to any position between the insertion position and the protruding position in the first direction, the first electrical contact portion 224 is in electrical contact with the second electrical contact portion 171.

In this way, it is convenient to implement an electrical connection between the fan module 200 and the power supply device when the fan module 200 moves to any position between the insertion position and the protruding position. In addition, the electrical connection device 5 has little impact on movement of the fan module 200 in the fan installation cavity 110.

For example, the second electrical contact portion 171 is of a strip structure extending in the first direction. When the fan module 200 is at the protruding position, the first electrical contact portion 224 is located in the fan installation cavity 110.

In this way, the first electrical contact portion 224 is not easily damaged due to moving to the outer side of the housing assembly 1.

In some examples in which the second electrical contact portion 171 is of a strip structure extending in the first direction, and the first electrical contact portion 224 is located in the fan installation cavity 110 when the fan module 200 is at the protruding position, a third sealing ring (not shown) may be disposed on an inner wall of the fan socket 50, and the third sealing ring is pressed tightly by the fan module 200 inserted into the fan socket 50 and the inner wall of the fan socket 50. The third sealing ring may be configured to hermetically connect, to the inner wall of the fan socket 50, the fan module 200 inserted into the fan socket 50.

In this way, it is convenient to implement sealing of the fan module 200 at the fan socket 50 when the fan module 200 moves to any position between the insertion position and the protruding position, and it is not easy for dust or liquid to enter the fan installation cavity 110.

In some possible implementations, the electrical connection device 5 may be a flexible printed circuit (flexible printed circuit, FPC). The flexible printed circuit may be connected to an insertion end of the fan module 200. When the fan module 200 is at the insertion position, a part of the flexible printed circuit located in the fan installation cavity 110 may be bent and accommodated in a side facing the insertion end of the fan module 200. In this way, it is convenient to implement the electrical connection between the fan module 200 and the power supply device when the fan module 200 moves to any position between the insertion position and the protruding position.

In some possible implementations, a fan assembly 220 includes a fan 221. The fan 221 is configured to perform active air-cooling heat dissipation on the mobile terminal. A cover plate 210 is securely disposed at one end of the fan 221 in the first direction. When the mobile terminal is in a fan locked state, the fan 221 is locked and fastened to the first mechanical part 100. When the mobile terminal is in a fan unlocked state, the fan 221 is unfastened from the first mechanical part 100. At least a part of the fan 221 may protrude to the outer side of the housing assembly 1 through the fan socket 50, or at least a part of the fan 221 may be inserted back into the fan installation cavity 110 through the fan socket 50. In this case, the fan 221 is electrically connected to the electrical connection device 5. When the fan module 200 is provided with the first electrical contact portion 224, the fan 221 is provided with the first electrical contact portion.

In this way, a structure of the fan module 200 is simple, and it is convenient to set a fan 221 of a large size, to increase an air volume of the fan 221.

FIG. 26 is a diagram of a fan module according to an embodiment of this application.

As shown in FIG. 26, in some other possible implementations, a fan assembly 220 may include a fan base 222 and a fan 221, and the fan 221 is configured to perform active air-cooling heat dissipation on a mobile terminal. A cover plate 210 is securely disposed at one end of the fan base 222 in a first direction, the fan 221 is securely disposed on the fan base 222, the fan 221 is disposed on one side of the fan base 222 in a second direction, and the fan base 221 is configured to carry the fan 221. When the mobile terminal is in a fan locked state, the fan base 222 is locked and fastened to a first mechanical part 100. When the mobile terminal is in a fan unlocked state, the fan base 222 is unfastened from the first mechanical part 100; and the fan base 222 may drive the fan 221 to protrude to an outer side of a housing assembly 1 through a fan socket 50, or the fan base 222 may drive the fan 221 to be inserted back into a fan installation cavity 110 through the fan socket 50.

In this way, when the fan assembly 220 is partially located in the fan installation cavity 110, the entire fan 221 can protrude to the outer side of the housing assembly 1, to facilitate repair of the fan 221. In addition, it is also convenient to dispose another device like a heat dissipation structure 640 on the fan assembly 220, so that a structure of the fan module 200 is flexible.

For example, the heat dissipation structure 640 may include one or more of a heat dissipation fin, a heat pipe, a vapor chamber, and the like. The heat dissipation structure 640 may be configured to improve heat exchange efficiency during air-cooling heat dissipation, and improve a heat dissipation capability for a heat generation device and the entire mobile terminal.

In some possible implementations, the fan 221 is not detachably connected to the fan base 222, and the fan 211 cannot be detached from the fan base 222.

In some other possible implementations, the fan 221 is detachably connected to the fan base 222.

In this way, it is convenient to detach the fan 221 from the fan base 222 for routine maintenance or repair.

For example, the fan 221 may be detachably connected to the fan base 222 in a manner of clamping, fastener connection, or the like.

In some examples in which the fan assembly 220 includes the fan base 222 and the fan 221, the fan base 222 is electrically connected to an electrical connection device 5, and the fan 221 is electrically connected to the fan base 222, so that the fan 221 can be electrically connected to the electrical connection device 5 through the fan base 222. When the fan module 200 is provided with a first electrical contact portion 224, the fan base 222 may be provided with a first electrical contact portion 224, and the fan 221 is electrically connected to the first electrical contact portion 224.

For example, the fan base 222 may be in electrical contact, through a terminal, with the fan 221 installed on the fan base 222.

In some examples in which the fan module 200 includes an anti-detachment structure 630, the anti-detachment structure 630 may be disposed on the fan base 222.

The fan module 200 is provided with a module air intake vent and a module air exhaust vent. Air enters the fan module 200 through the module air intake vent, and flows out of the fan module 200 through the module air exhaust vent.

FIG. 27 is a diagram of another mobile terminal according to an embodiment of this application.

As shown in FIG. 27, in some possible implementations, a fan installation cavity 110 is in communication with a first device installation cavity 31. When a fan module 200 is at an insertion position, a module air intake vent and a module air exhaust vent are located in the fan installation cavity 110 and are in communication with the fan installation cavity 110.

In this way, the fan module 200 can drive air circulation in the first device installation cavity 31 and the fan installation cavity 110, to achieve an effect of temperature equalization. In addition, there is no need to dispose an air vent on an outer surface of the mobile terminal, and an appearance of the mobile terminal is not affected.

For example, the module air exhaust vent of the fan module 200 may face a heat generation device like a chip 6, to form an effect of jet heat exchange, so that a temperature of the heat generation device like the chip 6 is reduced.

In an example in which the fan installation cavity 110 is in communication with the first device installation cavity 31, when the fan module 200 is at a protruding position and is electrically connected to a power supply device, the fan module 200 may obtain fresh air from an outer side of a housing assembly that enters and exits the first device installation cavity 31, so that hot air in the first device installation cavity 31 is replaced, thereby improving an effect of heat dissipation on the heat generation device in the first device installation cavity 31.

FIG. 28 is a diagram of another mobile terminal according to an embodiment of this application.

As shown in FIG. 28, in some other possible implementations, a fan installation cavity 110 and a first device installation cavity 31 are isolated from each other, and a heat generation device is connected to a first mechanical part 100 through a heat-conducting assembly 700. A fan module 200 is provided with a module air intake vent and a module air exhaust vent. Both the module air intake vent and the module air exhaust vent are in communication with an outer side of a housing assembly 1.

In this case, the heat generation device may transfer heat to the first mechanical part 100, and the fan module 200 obtains fresh air from the outer side of the housing assembly 1 to dissipate heat on the first mechanical part 100.

In this way, heat dissipation performance of the fan module 200 is good. In addition, when the fan module 200 is located at a protruding position, sealing performance of the first device installation cavity 31 is not damaged, and the sealing performance of the first device installation cavity 31 is good.

In an example in which the fan installation cavity 110 is isolated from the first device installation cavity 31, the fan installation cavity 110 and the first device installation cavity 31 are located in two sealing waterproof and dustproof systems that are independent of each other, and electrical connection portions and the like of a mainboard 3, a battery 4, a chip 6, and a display 2 are disposed in a sealing waterproof and dustproof system in which the first device installation cavity 31 is located, and are physically isolated from the fan installation cavity 110. Heat generated by the devices such as the mainboard 3, the battery 4, the chip 6, and the display 2 may be transferred to the first mechanical part 100 through the heat-conducting assembly 700, and heat is dissipated to an external environment through forced convection of the fan module 200, so that the mobile terminal can have good heat dissipation performance.

The fan installation cavity 110 and the first device installation cavity 31 are located in the two sealing waterproof and dustproof systems that are independent of each other. During routine maintenance and repair of the fan module 200, or when waterproofness of the fan installation cavity 110 fails, sealing, waterproof, and dustproof performance of the first device installation cavity 31 in which the electrical connection portions and the like of the mainboard 3, the battery 4, the chip 6, and the display 2 are located is not affected, and the devices in the first device installation cavity 31 can operate properly and reliably. Therefore, there is a strong system fault tolerance design capability and system waterproof and dustproof robustness for the fan module 200. This facilitates routine maintenance and repair without damage for the fan module 200.

In some examples, a waterproof and dustproof level of the fan installation cavity 110 is lower than a waterproof and dustproof level of the first device installation cavity 31. In this way, disposing and ventilating of the fan module 200 is easy.

For example, the waterproof and dustproof level of the fan installation cavity 110 may be IP57 or IP67, and the waterproof and dustproof level of the first device installation cavity 31 may be IP68 or higher.

When the housing assembly 1 includes a decoration part 20, and the first device installation cavity 31 is in communication with a second device installation cavity 41, the waterproof and dustproof level of the first device installation cavity 31 is a waterproof and dustproof level of an entire cavity formed by communicating the first device installation cavity 31 with the second device installation cavity 41.

In some examples, the heat-conducting assembly 700 may include a thermal interface material 710, and the heat generation device like the chip 6 may be connected to the first mechanical part 100 through the thermal interface material 710.

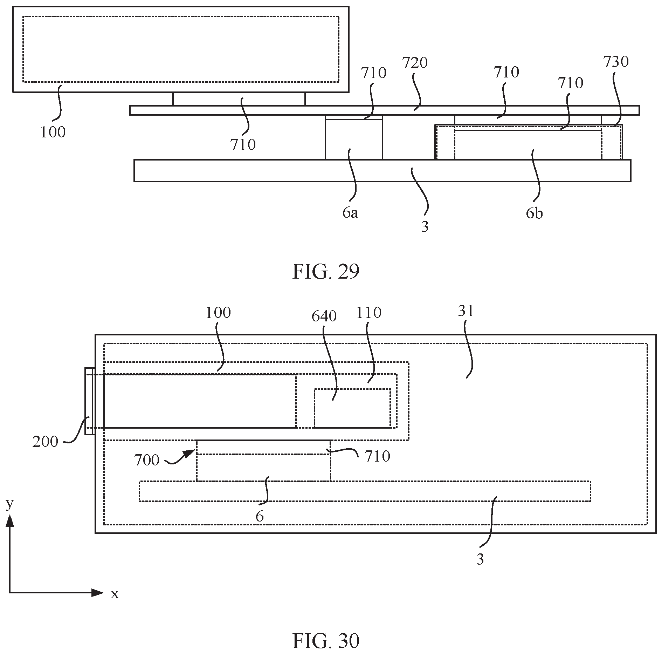

FIG. 29 is a diagram of another mobile terminal according to an embodiment of this application.

As shown in FIG. 29, a first chip 6a and a second chip 6b are disposed on a mainboard 3, a heat-conducting assembly 700 includes a heat-conducting plate 720, a thermal interface material 710, and a shielding cover 730. The heat-conducting plate 720 is connected to a first mechanical part 100 through the thermal interface material 710, the first chip 6a is connected to the heat-conducting plate 720 through the thermal interface material 710, the shielding cover 730 is disposed on an outer side of the second chip 6b, the second chip 6b is connected to an inner wall of the shielding cover 730 through the thermal interface material 710, and an outer wall of the shielding cover 730 is connected to the heat-conducting plate 720 through the thermal interface material 710.

For example, the heat-conducting plate 720 may include but is not limited to a vapor chamber, a graphite plate, a middle frame, and the like.

In some examples, the heat-conducting assembly 700 may include the heat-conducting plate 720, the heat-conducting plate 720 may be of an integrated structure with the first mechanical part 100, and the heat-conducting plate 720 may be connected to a heat generation device through the thermal interface material 710.

In some examples, the heat-conducting assembly 700 may include the shielding cover 730, the shielding cover 730 may be of an integrated structure with the first mechanical part 100, and the shielding cover 730 may be connected to the heat generation device through the thermal interface material 710.

FIG. 30 is a diagram of another mobile terminal according to an embodiment of this application.

As shown in FIG. 30, in some possible implementations, a first mechanical part 100 is securely connected to a heat dissipation structure 640, the heat dissipation structure 640 is located in a fan installation cavity 110, and heat on a heat generation device may be transferred to the heat dissipation structure 640 through the first mechanical part 100. A fan module 200 may dissipate heat on the heat dissipation structure 640 by obtaining fresh air from an outer side of a housing assembly 1.

In this way, efficiency of heat conduction between the first mechanical part 100 and the heat dissipation structure 640 is high, and efficiency of heat dissipation performed by the fan module 200 for the first mechanical part 100 is high.

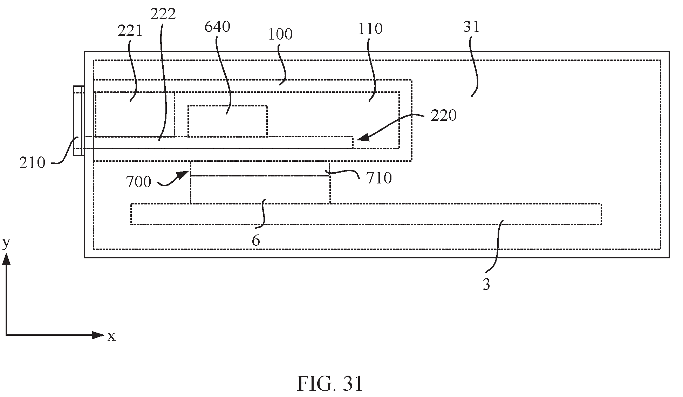

FIG. 31 is a diagram of another mobile terminal according to an embodiment of this application.

As shown in FIG. 31, in some examples in which a fan assembly 220 of a fan module 200 includes a fan base 222, the fan assembly 220 may include a heat dissipation structure 640. The heat dissipation structure 640 is securely connected to the fan base 222, and the heat dissipation structure 640 exchanges heat with a first mechanical part 100 through the fan base 222. In other words, heat on a heat generation device may be transferred to the heat dissipation structure 640 through the first mechanical part 100 and the fan base 222. In this way, when the fan module 200 is at a protruding position, at least a part of the heat dissipation structure 640 may be brought to an outer side of a housing assembly 1, to facilitate heat dissipation of the heat dissipation structure 640.

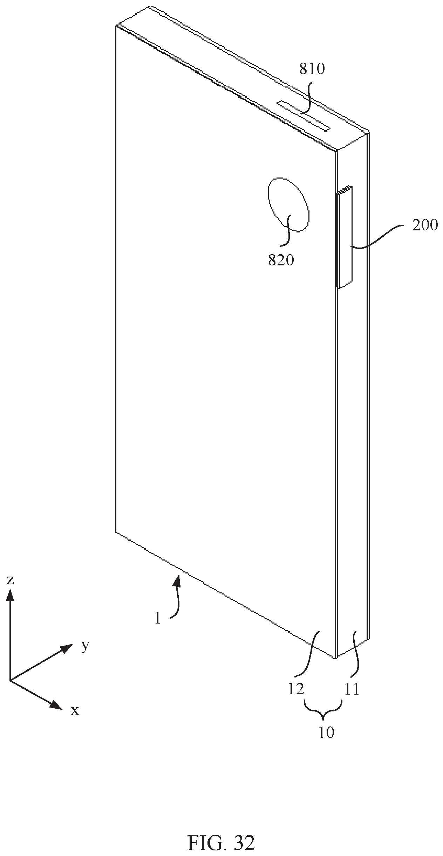

FIG. 32 is a diagram of another mobile terminal according to an embodiment of this application.

As shown in FIG. 32, in some possible implementations, a housing assembly 1 is provided with a first air vent 810 and a second air vent 820. Both the first air vent 810 and the second air vent 820 communicate a fan installation cavity 110 with an outer side of the housing assembly 1. When a fan module 200 is at an insertion position, both a module air intake vent and a module air exhaust vent are located in the fan installation cavity 110, one of the module air intake vent and the module air exhaust vent is in communication with the first air vent 810 through the fan installation cavity 110, and the other one of the module air intake vent and the module air exhaust vent is in communication with the second air vent 820.

In this way, air intake and air exhaust of the fan module 200 are less limited by a size of the fan module 200, so that air intake and air exhaust of the fan module 200 with a large air volume can be implemented.

For example, when the fan module 200 is at the insertion position, the first air vent 810 is in communication with the module air exhaust vent, and the second air vent 820 is in communication with the module air intake vent. Air in an external environment may flow to a heat dissipation structure 640 through the second air vent 820 and a fan 211 for heat exchange, and air after heat exchange then flows out of the fan installation cavity 110 through the first air vent 810; or air in an external environment may flow to a heat dissipation structure 640 through the second air vent 820 for heat exchange, and air then flows out of the fan installation cavity 110 through a fan 211 and the first air vent 810.

The communication between the first air vent 810 and the second air vent 820, and the module air intake vent and the module air exhaust vent depends on an architecture design. This is not limited in this application. For example, a left or right side edge of the housing assembly 1 may be provided with the second air vent 820 for air to enter. After the air flows through the fan module 200 and the heat sink 640, air is then exhausted through the first air vent 810 on an upper side edge of the housing assembly 1.

In some examples, the second air vent 820 and a decoration part 20 may be processed as a whole. For example, a side edge or a front side of the decoration part 20 is provided with the second air vent 820.

For example, dustproof structures may be disposed on the first air vent 810 and the second air vent 820, so that dust is difficult to enter the fan module 200 and the fan installation cavity 110. In addition, it is also convenient to remove dust from the dustproof structures. A waterproof and dustproof assembly may include a dustproof structure.

For example, the dustproof structure may include an air filter.

For example, when the first mechanical part 100 is securely connected to a side edge 11, and a second direction is a thickness direction of the mobile terminal, the side edge 11 may be provided with the first air vent 810, and a rear cover 12 may be provided with the second air vent 820. In this case, the fan 211 of the fan module 200 may use a mechanical centrifugal fan that draws in air in the thickness direction of the mobile terminal and exhausts air in a direction perpendicular to the air intake direction. In a high-power-consumption or high-performance mode, the fan module 200 may protrude outside the housing assembly 1, so that air intake resistance is greatly reduced. In this way, high-performance air intake is implemented, air flowing through the heat dissipation structure 640 is large, and heat dissipation performance is good.

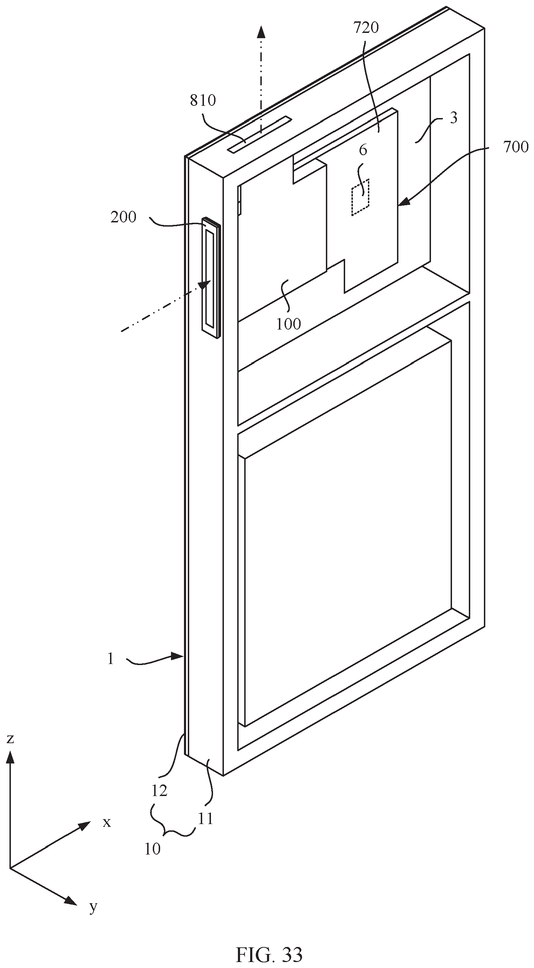

FIG. 33 is a diagram of another mobile terminal according to an embodiment of this application.

As shown in FIG. 33, in some possible implementations, a housing assembly 1 is provided with a first air vent 810, and the first air vent 810 communicates a fan installation cavity 110 with an outer side of the housing assembly 1. When a fan module 200 is at an insertion position, one of a module air intake vent and a module air exhaust vent is located in the fan installation cavity 110 and is in communication with the first air vent 810 through the fan installation cavity 110, and the other one of the module air intake vent and the module air exhaust vent is located at one end that is of the fan module 200 and that faces the outer side of the housing assembly 1 in a first direction.

In this way, air can enter and exit the fan installation cavity 110 smoothly, and heat dissipation efficiency of the fan module 200 is high. In addition, there are few openings on the housing assembly 1, and impact on an appearance of the housing assembly 1 is small. In addition, openings on a first mechanical part 100 and a requirement for an air duct formed by the first mechanical part 100 may be reduced. This can make a structure of the first mechanical part 100 simple.

For example, when the fan module 200 is at the insertion position, the first air vent 810 is in communication with the module air exhaust vent. Air in an external environment may flow to a heat dissipation structure 640 through the module air intake vent and a fan 211 for heat exchange, and air after heat exchange then flows out of the fan installation cavity 110 through the first air vent 810; or air in an external environment may flow to a heat dissipation structure 640 through the module air intake vent for heat exchange, and air then flows out of the fan installation cavity 110 through a fan 211 and the first air vent 810.

For example, dustproof structures may be disposed on the first air vent 810, and the module air intake vent and the module air exhaust vent that are located at one end that is of the fan module 200 and that faces the outer side of the housing assembly 1 in the first direction, so that dust is difficult to enter the fan module 200 and the fan installation cavity 110. In addition, it is also convenient to remove dust from the dustproof structures.

In some possible implementations, the housing assembly 1 is provided with the first air vent 810, and the first air vent 810 communicates the fan installation cavity 110 with the outer side of the housing assembly 1. When the fan module 200 is at a protruding position, the module air intake vent is located on the outer side of the housing assembly 1, and the module air exhaust vent is located in the fan installation cavity 110 and is in communication with the first air vent 810. When the fan module is at the insertion position, both the module air intake vent and the module air exhaust vent are located in the fan installation cavity. In this way, when the fan module 200 is at the protruding position, air in the external environment may flow through the module air intake vent and the fan installation cavity 110, and air flows back to the external environment through the first air vent 810, to perform active air-cooling heat dissipation.

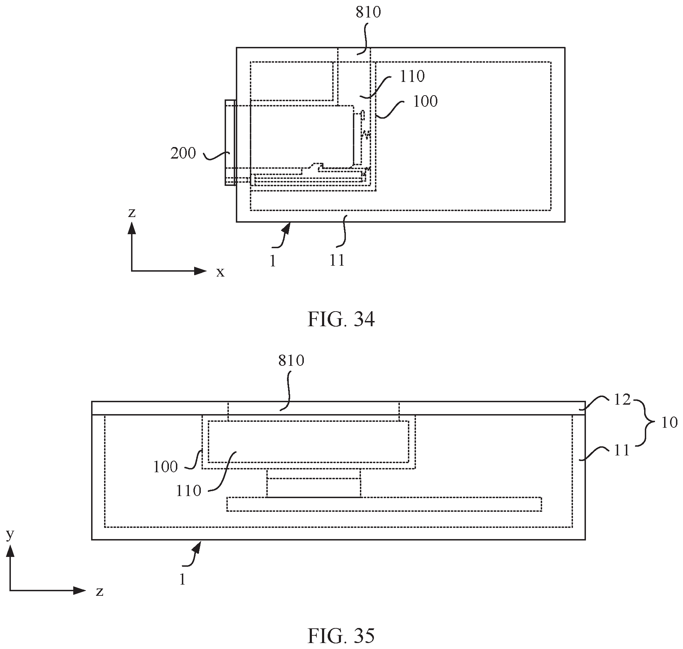

FIG. 34 is a diagram of another mobile terminal according to an embodiment of this application.

As shown in FIG. 34, an orientation of a first air vent 810 may be perpendicular to a second direction. For example, when a first mechanical part 100 is securely connected to a side edge 11, and the second direction is a thickness direction of the mobile terminal, the side edge 11 may be provided with the first air vent 810. In this way, thickness of the mobile terminal is reduced.

FIG. 35 is a diagram of another mobile terminal according to an embodiment of this application.

As shown in FIG. 35, a first air vent 810 may face a second direction. For example, when a first mechanical part 100 is securely connected to a side edge 11, and the second direction is a thickness direction of the mobile terminal, a rear cover 12 may be provided with the first air vent 810. In this way, a length of the first mechanical part 100 and space occupied by the first mechanical part 100 in a housing assembly 1 are reduced.

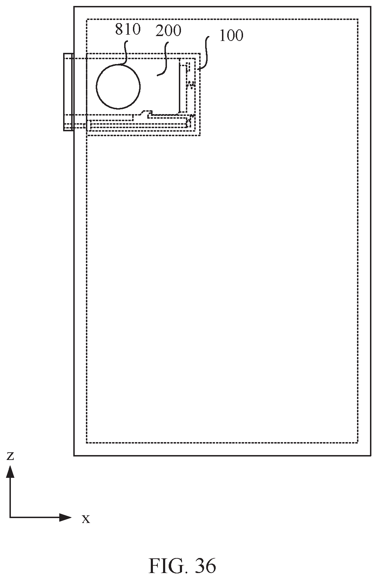

FIG. 36 is a diagram of another mobile terminal according to an embodiment of this application.

As shown in FIG. 36, in some examples in which a first air vent 810 is located on a rear cover 12, a projection of the first air vent 810 in a second direction is located in a projection of a fan module 200 at an insertion position in the second direction. In this way, a length of a first mechanical part 100 and space occupied by the first mechanical part 100 in a housing assembly 1 are reduced.

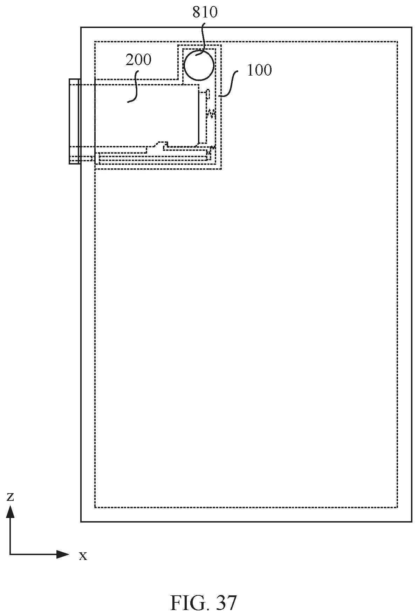

FIG. 37 is a diagram of another mobile terminal according to an embodiment of this application.

As shown in FIG. 37, in some other examples in which a first air vent 810 is located on a rear cover 12, a projection of the first air vent 810 in a second direction is located outside a projection of a fan module 200 at an insertion position in the second direction. In this way, air intake or air exhaust of the fan module 200 can be easy.

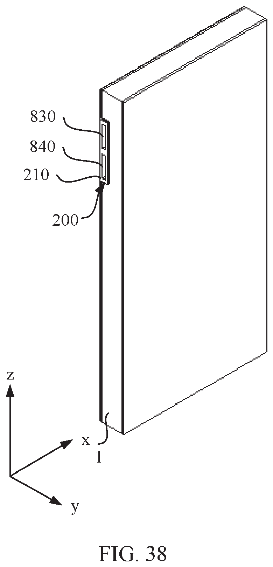

FIG. 38 is a diagram of another mobile terminal according to an embodiment of this application.

As shown in FIG. 38, in some possible implementations, a cover plate 210 of a fan module 200 is provided with a third air vent 830 and a fourth air vent 840, one of the third air vent 830 and the fourth air vent 840 is a module air intake vent, and the other one of the third air vent 830 and the fourth air vent 840 is a module air exhaust vent. A fan 221 of the fan module 200 is provided with a fan air intake vent and a fan air exhaust vent.

In some examples, one of the fan air intake vent and the fan air exhaust vent is in communication with an outer side of a housing assembly 1 through the third air vent 830. When the fan module 200 is at an insertion position, the other one of the fan air intake vent and the fan air exhaust vent is located in a fan installation cavity 110, and the fourth air vent 840 communicates the fan installation cavity 110 with the outer side of the housing assembly 1.

In this way, fresh air in the outer side of the housing assembly 1 may be exchanged with air in the fan installation cavity 110 through the third air vent 830 and the fourth air vent 840, to dissipate heat for the mobile terminal. In addition, the housing assembly 1 may not need to be provided with an air vent, and an appearance of the housing assembly 1 is not affected. In addition, openings on a first mechanical part 100 and a requirement for an air duct formed by the first mechanical part 100 may be reduced. This can make a structure of the first mechanical part 100 simple, and also help reduce a thickness of the mobile terminal.

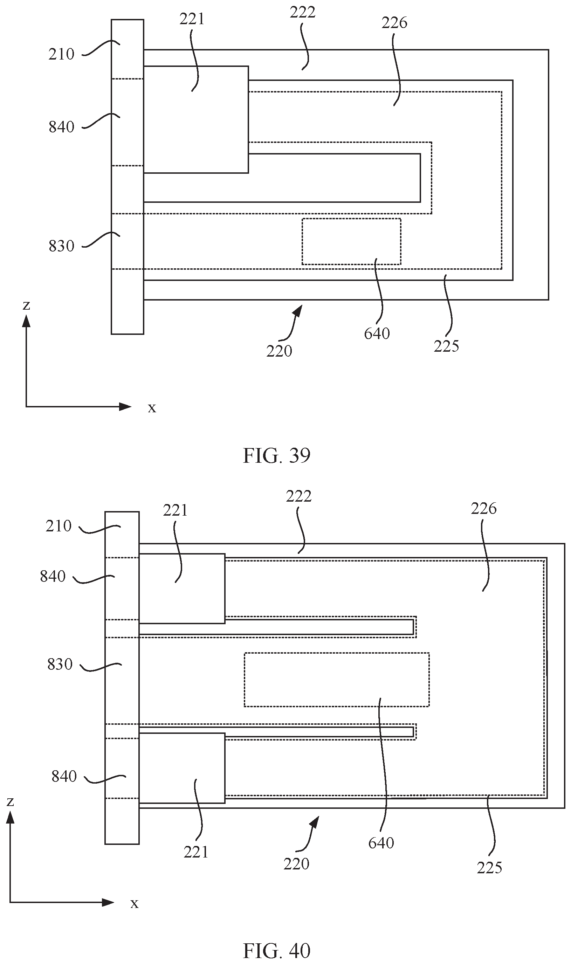

FIG. 39 is a diagram of another mobile terminal according to an embodiment of this application.

As shown in FIG. 39, in some examples in which a heat dissipation structure 640 is securely connected to a fan base 222, a fan assembly 220 of a fan module 200 further includes a second mechanical part 225. The second mechanical part 225 is securely disposed on the fan base 222, the second mechanical part 225 is configured to form a module air duct 226, and a third air vent 830 communicates an outer side of a housing assembly 1 with the module air duct 226. One of a fan air intake vent and a fan air exhaust vent is in communication with the third air vent 830 through the module air duct 226, the other one of the fan air intake vent and the fan air exhaust vent is in communication with the outer side of the housing assembly 1 through a fourth air vent 840, and the heat dissipation structure 640 is disposed in the module air duct 226.

In this way, fresh air in the outer side of the housing assembly 1 may be exchanged with air in the module air duct 226 through the third air vent 830 and the fourth air vent 840, to dissipate heat for the mobile terminal. In addition, the housing assembly 1 may not need to be provided with an air vent, and an appearance of the housing assembly 1 is not affected. In addition, openings on a first mechanical part 100 and a requirement for an air duct formed by the first mechanical part 100 may be reduced. This can make a structure of the first mechanical part 100 simple, and also help reduce a thickness of the mobile terminal. In addition, when the fan module 200 is at a protruding position, the running fan 221 may continue to dissipate heat for the heat dissipation structure 640.

FIG. 40 is a diagram of another mobile terminal according to an embodiment of this application.

As shown in FIG. 40, in some examples, a fan assembly 220 includes a plurality of fans 221, and a cover plate 210 is provided with a plurality of fourth air vents 840 that are in one-to-one correspondence with the fans 221. One of a fan air intake vent and a fan air exhaust vent of each fan 221 is in communication with a third air vent 830 through a module air duct 226, and the other one of the fan air intake vent and the fan air exhaust vent of each fan 221 is in communication with an outer side of a housing assembly 1 through a corresponding fourth air vent 840. In this way, a fan module 200 can have a good heat dissipation effect.

In some possible implementations, the fan module 200 is a piezoelectric fan module. In other words, the fan 221 of the fan module 200 is a piezoelectric fan. In this way, a thickness of the piezoelectric fan is thin. This facilitates reduction of a thickness of the fan module 200, reduces requirements on sizes of the housing assembly 1 and a fan socket 50, and facilitates disposing of the fan module 200 on the mobile terminal. In addition, air intake and air exhaust directions of the piezoelectric fan are flexible, so that the fan module 200 can be flexibly disposed. In addition, a pressure head of the piezoelectric fan is large. This facilitates disposing of a dustproof structure 650 with a waterproof and breathable film at an air intake end and an air exhaust end.

In an example in which the fan module 200 is the piezoelectric fan module, the dustproof structure 650 with the waterproof and breathable film is disposed on a module air intake vent and a module air exhaust vent of the fan module 200. In this way, dust can hardly enter the fan module 200, and the piezoelectric fan that is sensitive to dust can run reliably.

For example, the dustproof structure 650 with the waterproof and breathable film may include the waterproof and breathable film and an air filter. Both the air filter and the waterproof and breathable film are securely connected to the fan module 200, and the waterproof and breathable film is disposed in an inner side of the air filter. In other words, at the module air intake vent, air first flows through the air filter, and then enters the fan module 200 through the waterproof and breathable film; and at the module air exhaust vent, air in the fan module 200 first flows through the waterproof and breathable film, and then flows out of the fan module 200 through the air filter.

When the fan module 200 is a piezoelectric fan module, a waterproof and dustproof level of a fan installation cavity 110 may be IP67 or higher.

In some other possible implementations, the fan module 200 is a mechanical fan module. In other words, the fan 221 of the fan module 200 is a mechanical fan, for example, may be a centrifugal fan.

In the descriptions of embodiments of this application, it should be noted that, unless otherwise clearly specified and limited, the term "installation", "connected to", or "connection" should be understood in a broad sense, for example, may be secure fastening, may be an indirect connection through an intermediate medium, or may be internal communication between two elements or an interaction relationship between two elements. A person of ordinary skill in the art may understand specific meanings of the foregoing terms in embodiments of this application based on specific cases.

An apparatus or element in embodiments of this application or an implied apparatus or element needs to have a specific orientation and be constructed and operated in a specific orientation. Therefore, this should not be understood as a limitation on embodiments of this application. In the descriptions of embodiments of this application, "a plurality of" means two or more, unless otherwise precisely and specifically specified.

In the specification, claims, and accompanying drawings of embodiments of this application, the terms "first", "second", "third", "fourth", and the like (if existent) are intended to distinguish between similar objects but do not necessarily indicate a specific order or sequence. It should be understood that the data used in such a way is interchangeable in proper circumstances, so that embodiments of this application described herein can be implemented in an order other than the order illustrated or described herein. In addition, the terms "include" and "have" and any other variants are intended to cover the non-exclusive inclusion. For example, a process, method, system, product, or device that includes a list of steps or units is not necessarily limited to those expressly listed steps or units, but may include other steps or units not expressly listed or inherent to such a process, method, product, or device.

The term "a plurality of" in this specification means two or more. The term "and/or" in this specification describes only an association relationship for describing associated objects and represents that three relationships may exist. For example, A and/or B may represent the following three cases: Only A exists, both A and B exist, and only B exists. In addition, a character "/" in this specification usually indicates an "or" relationship between associated objects, and a character "/" in a formula usually indicates a "divisible" relationship between associated objects.

It may be understood that various numbers in embodiments of this application are merely used for differentiation for ease of description, and are not used to limit the scope of embodiments of this application.

It may be understood that sequence numbers of the foregoing processes do not mean execution sequences in embodiments of this application. The execution sequences of the processes should be determined based on functions and internal logic of the processes, and should not be construed as any limitation on the implementation processes of embodiments of this application.

## Claims

1. A mobile terminal, comprising a housing assembly (1), a fan module (200), and a first mechanical part (100), wherein
the first mechanical part (100) is securely disposed on an inner wall of the housing assembly (1), and the first mechanical part (100) and the housing assembly (1) enclose a fan installation cavity (110);
the housing assembly (1) is provided with a fan socket (50) communicating the fan installation cavity (110) with an outer side of the housing assembly (1), and the fan module (200) is inserted into the fan installation cavity (110) through the fan socket (50);
the mobile terminal has a fan locked state and a fan unlocked state;
when the mobile terminal is in the fan locked state, the fan module (200) is locked and fastened to the first mechanical part (100);
when the mobile terminal is in the fan unlocked state, the fan module (200) is unfastened from the first mechanical part (100), and the fan module (200) is movable between an insertion position and a protruding position in a first direction, to enable at least a part of the fan module (200) to protrude to the outer side of the housing assembly (1) through the fan socket (50), or at least a part of the fan module (200) to be inserted back into the fan installation cavity (110) through the fan socket (50); and
the first direction is a plugging direction of the fan module (200).

2. The mobile terminal according to claim 1, further comprising a power supply device and an electrical connection device (5), wherein
the housing assembly (1) is further provided with a device installation cavity located outside the fan installation cavity (110), the power supply device is disposed in the device installation cavity, a part of the electrical connection device (5) is located in the device installation cavity, and a part of the electrical connection device (5) is located in the fan installation cavity (110); and
when the fan module (200) is at the insertion position, the fan module (200) is electrically connected to the power supply device through the electrical connection device (5).

3. The mobile terminal according to claim 1, further comprising a power supply device and an electrical connection device (5), wherein
the housing assembly (1) is further provided with a device installation cavity located outside the fan installation cavity (110), the power supply device is disposed in the device installation cavity, a part of the electrical connection device (5) is located in the device installation cavity, and a part of the electrical connection device (5) is located in the fan installation cavity (110); and
when the fan module (200) is at the protruding position, the fan module (200) is electrically connected to the power supply device through the electrical connection device (5).

4. The mobile terminal according to claim 2 or 3, wherein when the fan module (200) moves to any position between the insertion position and the protruding position in the first direction, the fan module (200) is electrically connected to the power supply device through the electrical connection device (5).

5. The mobile terminal according to any one of claims 2 to 4, wherein the electrical connection device (5) comprises an electrical contact terminal (170) securely disposed on the first mechanical part (100), and the fan module (200) is provided with a first electrical contact portion (224);
the electrical contact terminal (170) comprises a second electrical contact portion (171) located in the fan installation cavity (110) and a connection portion (172) located in the device installation cavity, and the connection portion (172) is electrically connected to the power supply device; and
the first electrical contact portion (224) is configured to be in electrical contact with the second electrical contact portion (171), to enable the fan module (200) to be electrically connected to the power supply device through the electrical contact terminal (170).

6. The mobile terminal according to claim 5, wherein at least one of the second electrical contact portion (171) and the first electrical contact portion (224) is of a strip structure extending in the first direction;
when the fan module (200) is at the protruding position, a part of the fan module (200) is located in the fan installation cavity (110), a part of the fan module (200) protrudes to the outer side of the housing assembly (1) through the fan socket (50), and at least a part of the first electrical contact portion (224) is located in the fan installation cavity (110); and
when the fan module (200) moves to any position between the insertion position and the protruding position in the first direction, the first electrical contact portion (224) is in electrical contact with the second electrical contact portion (171).

7. The mobile terminal according to any one of claims 1 to 6, wherein the fan module (200) comprises a cover plate (210) and a fan assembly (220);
the cover plate (210) is securely disposed at one end of the fan assembly (220) in the first direction, the fan assembly (220) is inserted into the fan installation cavity (110) through the fan socket (50), and the cover plate (210) is located on the outer side of the housing assembly (1);
when the fan module (200) is at the insertion position, the cover plate (210) covers an outer surface of the housing assembly (1), and an orthographic projection of the cover plate (210) on the outer surface of the housing assembly (1) covers an edge of the housing assembly (1) at the fan socket (50); and
when the fan module (200) moves between the insertion position and the protruding position in the first direction, at least a part of the fan assembly (220) protrudes to the outer side of the housing assembly (1) through the fan socket (50), or at least a part of the fan assembly (220) is inserted back into the fan installation cavity (110) through the fan socket (50).

8. The mobile terminal according to claim 7, further comprising a sealing ring, wherein the sealing ring is disposed between the cover plate (210) and the outer surface of the housing assembly (1), and the sealing ring is disposed around the fan socket (50) in a circumferential direction of the fan socket (50); and
when the fan module (200) is at the insertion position, the sealing ring is pressed tightly by the cover plate (210) and the outer surface of the housing assembly (1), and the sealing ring enables the fan module (200) to be hermetically connected to the housing assembly (1) at the fan socket (50).

9. The mobile terminal according to claim 7 or 8, wherein the fan assembly (220) comprises a fan base (222) and a fan (221);
the cover plate (210) is securely disposed at one end of the fan base (222) in the first direction, the fan (221) is securely disposed on the fan base (222), and the fan (221) is disposed on one side of the fan base (222) in a second direction;
when the mobile terminal is in the fan locked state, the fan base (222) is locked and fastened to the first mechanical part (100);
when the mobile terminal is in the fan unlocked state, the fan base (222) is unfastened from the first mechanical part (100); and the fan base (222) drives the fan (221) to protrude to the outer side of the housing assembly (1) through the fan socket (50), or the fan base (222) drives the fan (221) to be inserted back into the fan installation cavity (110) through the fan socket (50); and
the second direction is perpendicular to the first direction.

10. The mobile terminal according to claim 9, wherein the fan (221) is detachably connected to the fan base (222).

11. The mobile terminal according to any one of claims 1 to 10, further comprising a heat generation device, wherein the heat generation device is disposed in the device installation cavity of the housing assembly (1), and the fan installation cavity (110) is in communication with the device installation cavity;
the fan module (200) is provided with a module air intake vent and a module air exhaust vent; and
when the fan module (200) is at the insertion position, the module air intake vent and the module air exhaust vent are located in the fan installation cavity (110) and are in communication with the fan installation cavity (110).

12. The mobile terminal according to any one of claims 1 to 10, further comprising a heat generation device, wherein the heat generation device is disposed in the device installation cavity of the housing assembly (1);
the fan installation cavity (110) is isolated from the device installation cavity, and the heat generation device is connected to the first mechanical part (100) through a heat-conducting assembly (700);
the fan module (200) is provided with a module air intake vent and a module air exhaust vent; and
both the module air intake vent and the module air exhaust vent are in communication with the outer side of the housing assembly (1).

13. The mobile terminal according to claim 12, wherein a waterproof and dustproof level of the fan installation cavity (110) is lower than a waterproof and dustproof level of the device installation cavity.

14. The mobile terminal according to claim 12 or 13, wherein a heat dissipation structure (640) is securely connected to the first mechanical part (100), and the heat dissipation structure (640) is located in the fan installation cavity (110).

15. The mobile terminal according to claim 12 or 13, wherein the fan assembly (220) of the fan module (200) comprises a heat dissipation structure (640), the heat dissipation structure (640) is securely connected to the fan base (222) of the fan assembly (220), and the heat dissipation structure (640) exchanges heat with the first mechanical part (100) through the fan base (222).

16. The mobile terminal according to any one of claims 12 to 15, wherein the housing assembly (1) is provided with a first air vent (810) and a second air vent (820), and both the first air vent (810) and the second air vent (820) communicate the fan installation cavity (110) with the outer side of the housing assembly (1); and
when the fan module (200) is at the insertion position, both the module air intake vent and the module air exhaust vent are located in the fan installation cavity (110), one of the module air intake vent and the module air exhaust vent is in communication with the first air vent (810) through the fan installation cavity (110), and the other one of the module air intake vent and the module air exhaust vent is in communication with the second air vent (820).

17. The mobile terminal according to any one of claims 12 to 15, wherein the housing assembly (1) is provided with a first air vent (810), and the first air vent (810) communicates the fan installation cavity (110) with the outer side of the housing assembly (1); and
when the fan module (200) is at the insertion position, one of the module air intake vent and the module air exhaust vent is located in the fan installation cavity (110) and is in communication with the first air vent (810) through the fan installation cavity (110), and the other one of the module air intake vent and the module air exhaust vent is located at one end that is of the fan module (200) and that faces the outer side of the housing assembly (1) in the first direction.

18. The mobile terminal according to any one of claims 12 to 15, wherein the cover plate (210) of the fan module (200) is provided with a third air vent (830) and a fourth air vent (840), one of the third air vent (830) and the fourth air vent (840) is the module air intake vent, and the other one of the third air vent (830) and the fourth air vent (840) is the module air exhaust vent;
the fan (221) of the fan module (200) is provided with a fan air intake vent and a fan air exhaust vent, and one of the fan air intake vent and the fan air exhaust vent is in communication with the outer side of the housing assembly (1) through the third air vent (830); and
when the fan module (200) is at the insertion position, the other one of the fan air intake vent and the fan air exhaust vent is located in the fan installation cavity (110), and the fourth air vent (840) communicates the fan installation cavity (110) with the outer side of the housing assembly (1).

19. The mobile terminal according to claim 15, wherein the cover plate (210) of the fan module (200) is provided with a third air vent (830) and a fourth air vent (840), one of the third air vent (830) and the fourth air vent (840) is the module air intake vent, and the other one of the third air vent (830) and the fourth air vent (840) is the module air exhaust vent;
the fan assembly (220) of the fan module (200) further comprises a second mechanical part (225), the second mechanical part (225) is securely disposed on the fan base (222), the second mechanical part (225) is configured to form a module air duct (226), and the third air vent (830) communicates the outer side of the housing assembly (1) with the module air duct (226); and
the fan (221) of the fan module (200) is provided with a fan air intake vent and a fan air exhaust vent, one of the fan air intake vent and the fan air exhaust vent is in communication with the third air vent (830) through the module air duct (226), the other one of the fan air intake vent and the fan air exhaust vent is in communication with the outer side of the housing assembly (1) through the fourth air vent (840), and the heat dissipation structure (640) is disposed in the module air duct (226).

20. The mobile terminal according to any one of claims 1 to 19, wherein the fan module (200) is a piezoelectric fan module, and a dustproof structure (650) with a waterproof and breathable film is disposed on the module air intake vent and the module air exhaust vent of the fan module (200).

21. The mobile terminal according to any one of claims 1 to 20, wherein the housing assembly (1) comprises a housing (10) and a decoration part (20);
the decoration part (20) is securely connected to the housing (10), and the decoration part (20) protrudes from an outer surface of the housing (10); and
the first mechanical part (100) is disposed in the decoration part (20), the first mechanical part (100) is securely disposed on an inner wall of the decoration part (20), the first mechanical part (100) and the decoration part (20) enclose the fan installation cavity (110), and the decoration part (20) is provided with the fan socket (50).

22. The mobile terminal according to any one of claims 1 to 21, wherein a locking mechanism (300) is disposed on the first mechanical part (100);
when the mobile terminal is in the fan locked state, the locking mechanism (300) enables the fan module (200) to be locked and fastened to the first mechanical part (100); and
when the mobile terminal is in the fan unlocked state, the locking mechanism (300) enables the fan module (200) to be unfastened from the first mechanical part (100).

23. The mobile terminal according to any one of claims 1 to 22, wherein an anti-detachment structure (630) is securely disposed on the fan module (200), the anti-detachment structure (630) is located in the fan installation cavity (110), and the anti-detachment structure (630) is configured to abut against the inner wall of the housing assembly (1) when the fan module (200) is at the protruding position, to limit, from being detached from the housing assembly (1) through the fan socket (50), the fan module (200) inserted into the fan installation cavity (110).

24. The mobile terminal according to any one of claims 1 to 23, wherein a push-out mechanism (400) is further disposed in the housing assembly (1);
at least a part of the push-out mechanism (400) is located in the fan installation cavity (110); and
the push-out mechanism (400) is configured to push a part of the fan module (200) at the insertion position to the outer side of the housing assembly (1) through the fan socket (50).
